# EUROPEAN PATENT APPLICATION

(11) **EP 4 524 947 A1**
(43) Date of publication of application: **19.03.2025**
(21) Application number: 22944266.0
(22) Date of filing: 31.05.2022
(51) Int. Cl.: G09G 3/34, H01L 33/00, H01L 27/15

(54) **CHIP STRUCTURE, CHIP PREPARATION METHOD, DISPLAY SUBSTRATE, AND DISPLAY APPARATUS**

(71) Applicant: Boe Technology Group Co., Ltd., Beijing 100015 (CN)
(72) Inventor: LI, Wei, Beijing 100176 (CN); WANG, Mingxing, Beijing 100176 (CN); SUN, Qian, Beijing 100176 (CN); YAN, Huajie, Beijing 100176 (CN); JIAO, Zhiqiang, Beijing 100176 (CN); LIANG, Xuan, Beijing 100176 (CN); JIN, Qian, Beijing 100176 (CN); LI, Xiang, Beijing 100176 (CN); WANG, Can, Beijing 100176 (CN); XUAN, Minghua, Beijing 100176 (CN); ZHANG, Can, Beijing 100176 (CN)
(74) Representative: Hoffmann Eitle
(86) International application number: PCT/CN2022/096491
(87) International publication number: WO 2023/230932

(57) **Abstract**

A chip structure, a chip preparation method, and a display substrate and a display device using the chip structure. The chip structure comprises: a chip wafer unit and a color conversion layer substrate unit arranged on a light-emitting side of the chip wafer unit. The chip wafer unit comprises a plurality of sub-pixel light-emitting functional layers. The color conversion layer substrate unit comprises a color conversion layer arranged on the light-emitting side of the chip wafer unit. The chip wafer unit further comprises: a first bonding layer, arranged between the sub-pixel light-emitting functional layers and the color conversion layer and used for bonding the chip wafer unit and the color conversion layer substrate unit.

## Description

### TECHNICAL FIELD

The present disclosure relates to the field of display technologies, and in particular, to a chip structure, a chip manufacturing method, a display substrate and a display device.

### BACKGROUND

As a new generation display technology, Micro-LED (Micrometer-sized light-emitting diode) display elements have many advantages such as high brightness, high luminescence efficiency, low power consumption, and fast response speed. However, in a case of applying the Micro-LED for display devices, there are still some problems such as a mass transfer problem, and a product yield problem.

### SUMMARY

In an aspect, a chip structure is provided. The chip structure includes a chip wafer unit and a color conversion layer substrate unit arranged on a light-exit side of the chip wafer unit. The chip wafer unit includes a plurality of sub-pixel light-emitting functional layers. The color conversion layer substrate unit includes a color conversion layer arranged on the light-exit side of the chip wafer unit.

The chip wafer unit further includes a first bonding layer, arranged between the sub-pixel light-emitting functional layers and the color conversion layer, and configured to bond the chip wafer unit and the color conversion layer substrate unit.

In some embodiments, the first bonding layer includes a first metal sub-layer, a second metal sub-layer and a third metal sub-layer that are stacked; and the third metal sub-layer is closer to the color conversion layer substrate unit than the first metal sub-layer, and the second metal sub-layer is provided as a eutectic alloy layer connecting the first metal sub-layer and the third metal sub-layer.

In some embodiments, the first bonding layer includes a first bonding sub-layer and a second bonding sub-layer that are stacked. A material of the first bonding sub-layer and a material of the second bonding sub-layer are indium zinc oxide.

In some embodiments, the chip wafer unit includes a first sub-pixel light-emitting functional layer, a second sub-pixel light-emitting functional layer and a third sub-pixel light-emitting functional layer; and the first bonding layer includes a first opening area corresponding to the first sub-pixel light-emitting functional layer, a second opening area corresponding to the second sub-pixel light-emitting functional layer and a third opening area corresponding to the third sub-pixel light-emitting functional layer.

**In** some embodiments, the chip wafer unit further includes a common cathode layer; the first sub-pixel light-emitting functional layer includes a first quantum well, a first p-type gallium nitride and a first anode that are stacked along a first direction; the second sub-pixel light-emitting functional layer includes a second quantum well, a second p-type gallium nitride and a second anode that are stacked along the first direction; the third sub-pixel light-emitting functional layer includes a third quantum well, a third p-type gallium nitride and a third anode that are stacked along the first direction; and the common cathode layer includes a cathode metal and a cathode electrode that are stacked along the first direction, where the first direction is a direction from the color conversion layer substrate unit to the chip wafer unit.

In some embodiments, a material of the cathode metal of the common cathode layer includes any one of titanium, aluminum, nickel and gold.

In some embodiments, the chip wafer unit further includes a second bonding layer, the second bonding layer including a first bonding portion, a second bonding portion, a third bonding portion and a fourth bonding portion, where the first bonding portion is stacked between the first p-type gallium nitride and the first anode; the second bonding portion is stacked between the second p-type gallium nitride and the second anode; the third bonding portion is stacked between the third p-type gallium nitride and the third anode; and the cathode metal of the common cathode layer includes the fourth bonding portion.

In some embodiments, the second bonding layer includes a fourth metal sub-layer, a fifth metal sub-layer and a sixth metal sub-layer that are stacked, where the sixth metal sub-layer is farther from the color conversion layer substrate than the fourth metal sub-layer, and the fifth metal sub-layer is provided as a eutectic alloy layer connecting the sixth metal sub-layer and the fourth metal sub-layer.

In some embodiments, the chip wafer unit further includes a second bonding layer, where the first bonding layer includes a first metal sub-layer, a second metal sub-layer and a third metal sub-layer that are stacked, and a range of a maximum thickness of the first bonding layer is equal to a range of a thickness of the second bonding layer; or the first bonding layer includes a first bonding sub-layer and a second bonding sub-layer that are stacked, and a range of a thickness of the first bonding layer is less than a range of a thickness of the second bonding layer.

In some embodiments, the first bonding layer includes the first metal sub-layer, the second metal sub-layer and the third metal sub-layer that are stacked, and the range of the maximum thickness of the first bonding layer is of 3 µm to 6 µm, inclusive; or the first bonding layer includes the first bonding sub-layer and the second bonding sub-layer that are stacked, and the range of the thickness of the first bonding layer is of 200 nm to 1200 nm, inclusive; and the range of the thickness of the second bonding layer is of 3 µm to 6 µm, inclusive.

In some embodiments, the first bonding layer includes a first metal sub-layer, a second metal sub-layer and a third metal sub-layer that are stacked, where the second metal sub-layer is a eutectic alloy layer with a melting temperature of less than 240 °C.

In some embodiments, the chip wafer unit further includes an n-type gallium nitride conductive layer and a gallium nitride buffer layer that are stacked along a second direction, the second direction being a direction from the chip wafer unit to the color conversion layer substrate unit, where the n-type gallium nitride conductive layer is connected to the first quantum well, the second quantum well, the third quantum well and the cathode metal; and a region, corresponding to the first sub-pixel light-emitting functional layer, the second sub-pixel light-emitting functional layer and the third sub-pixel light-emitting functional layer, of the gallium nitride buffer layer is a first region, and a side of the first region facing the color conversion layer substrate is provided thereon with a plurality of first-type micro-protrusion structures; a portion of the gallium nitride buffer layer, which does not include the first region, is a second region, and the first bonding layer is located on a side of the gallium nitride buffer layer of the second region facing the color conversion layer substrate.

In some embodiments, the chip wafer unit further includes an n-type gallium nitride conductive layer, the n-type gallium nitride conductive layer including a first n-type gallium nitride, a second n-type gallium nitride, a third n-type gallium nitride and a fourth n-type gallium nitride; the first n-type gallium nitride is stacked on a side of the first quantum well away from the first p-type gallium nitride; the second n-type gallium nitride is stacked on a side of the second quantum well away from the second p-type gallium nitride; the third n-type gallium nitride is stacked on a side of the third quantum well away from the third p-type gallium nitride; the fourth n-type gallium nitride is stacked on a side of a fourth bonding region facing the color conversion layer substrate; and the first bonding layer is arranged on a side of the n-type gallium nitride conductive layer facing the color conversion layer substrate unit.

In some embodiments, the first metal sub-layer and the second metal sub-layer that are stacked include a first zone provided with the first opening area, a second zone provided with the second opening area, a third zone provided with the third opening area and a fourth zone covering the common cathode layer; and the third metal sub-layer covers the second metal sub-layer of the first zone, the second zone, the third zone and the fourth zone, and is configured as a conductive layer connecting the first n-type gallium nitride, the second n-type gallium nitride, the third n-type gallium nitride and the fourth n-type gallium nitride.

In some embodiments, a region, corresponding to the first sub-pixel light-emitting functional layer, the second sub-pixel light-emitting functional layer and the third sub-pixel light-emitting functional layer, of the n-type gallium nitride conductive layer is a third region, and a side of the third region facing the color conversion layer substrate unit is provided thereon with a plurality of second-type micro-protrusion structures.

In some embodiments, the chip wafer unit further includes a reflective metal layer, the reflective metal layer including a first reflective portion, a second reflective portion and a third reflective portion, where the first reflective portion is stacked between the first p-type gallium nitride and the first anode; the second reflective portion is stacked between the second p-type gallium nitride and the second anode; and the third reflective portion is stacked between the third p-type gallium nitride and the third anode.

In some embodiments, the chip wafer unit includes a second bonding layer, the second bonding layer including a first bonding portion, a second bonding portion, a third bonding portion and a fourth bonding portion, where the first reflective portion is stacked on a side of the first bonding portion facing the color conversion layer substrate unit; the second reflective portion is stacked on a side of the second bonding portion facing the color conversion layer substrate unit; and the third reflective portion is stacked on a side of the third bonding portion facing the color conversion layer substrate unit.

In some embodiments, a side of the second bonding layer facing the color conversion layer substrate unit is provided thereon with an insulating layer, the insulating layer being provided therein with a first via hole, a second via hole, a third via hole and a fourth via hole, where a fourth metal sub-layer of the first bonding portion fills the first via hole and is connected to the first reflective portion; a fourth metal sub-layer of the second bonding portion fills the second via hole and is connected to the second reflective portion; a fourth metal sub-layer of the third bonding portion fills the third via hole and is connected to the third reflective portion; and a fourth metal sub-layer of the fourth bonding portion fills the fourth via hole and is connected to the n-type gallium nitride conductive layer.

In some embodiments, the chip wafer unit includes a first sub-pixel light-emitting functional layer, a second sub-pixel light-emitting functional layer and a third sub-pixel light-emitting functional layer; and the color conversion layer includes a limiting dam layer, and a fourth opening area, a fifth opening area and a sixth opening area that are defined by the limiting dam layer, where the fourth opening area is provided therein with a first quantum dot conversion part corresponding to the first sub-pixel light-emitting functional layer; the fifth opening area is provided therein with a scattering particle part corresponding to the second sub-pixel light-emitting functional layer; and the sixth opening area is provided therein with a scattering particle part corresponding to the third sub-pixel light-emitting functional layer.

In some embodiments, an orthographic projection of the fourth opening area on the color conversion layer substrate unit covers an orthographic projection of the first sub-pixel light-emitting functional layer on the color conversion layer substrate unit; an orthographic projection of the fifth opening area on the color conversion layer substrate unit covers an orthographic projection of the second sub-pixel light-emitting functional layer on the color conversion layer substrate unit; and an orthographic projection of the sixth opening area on the color conversion layer substrate unit covers an orthographic projection of the third sub-pixel light-emitting functional layer on the color conversion layer substrate unit.

In some embodiments, the color conversion layer substrate unit further includes a light-gathering layer, the light-gathering layer being arranged on a side of the color conversion layer proximate to the chip wafer unit, where the light-gathering layer includes a first light-gathering portion corresponding to the first quantum dot conversion part, a second light-gathering portion corresponding to the scattering particle part, and a third light-gathering portion corresponding to the third quantum dot conversion part.

In some embodiments, the color conversion layer substrate unit further includes a substrate and a color filter layer; and the substrate, the color filter layer and the color conversion layer are stacked along a second direction, the second direction being a direction from the chip wafer unit to the color conversion layer substrate unit, where the color filter layer includes a black matrix, and a first light-filtering film corresponding to the first quantum dot conversion part, a second light-filtering film corresponding to the scattering particle part and a third light-filtering film corresponding to the scattering particle part that are defined by the black matrix.

In another aspect, a display substrate is provided. The display substrate includes the chip structure according to any one of the above embodiments.

In yet another aspect, a chip manufacturing method is provided. The chip manufacturing method includes: forming an initial chip wafer unit, the initial chip wafer unit including a temporary substrate, a plurality of sub-pixel light-emitting functional layers, a first initial metal sub-layer and a second initial metal sub-layer that are stacked, where the second initial metal sub-layer includes a plurality of first-type metal protrusions.

The chip manufacturing method further includes: forming a color conversion layer substrate unit, the color conversion layer substrate unit including a color conversion layer and a first substrate that are stacked; forming a third initial metal sub-layer on a side of the color conversion layer away from the first substrate; and bonding the first initial metal sub-layer, the second initial metal sub-layer and the third initial metal sub-layer to form a first bonding layer, the first bonding layer including a first metal sub-layer, a second metal sub-layer and a third metal sub-layer, where the second metal sub-layer is a eutectic alloy layer connecting the first metal sub-layer and the third metal sub-layer.

The chip manufacturing method further includes: peeling off the temporary substrate to form a chip wafer unit, where the chip wafer unit and the color conversion layer substrate unit are connected through the first bonding layer.

In some embodiments, a step of forming an initial chip wafer unit, includes: providing a second substrate; and forming the initial chip wafer unit on a side of the second substrate, the initial chip wafer unit including a plurality of initial sub-pixel light-emitting functional layers and an initial common cathode layer. The step of forming an initial chip wafer unit, further includes: forming the temporary substrate on a side, away from the second substrate, of the plurality of initial sub-pixel light-emitting functional layers and the initial common cathode layer of the initial chip wafer unit. The step of forming an initial chip wafer unit, further includes: peeling off the second substrate.

In some embodiments, steps of forming the initial chip wafer unit on a side of the second substrate, the initial chip wafer unit including a plurality of initial sub-pixel light-emitting functional layers and an initial common cathode layer, and forming the temporary substrate on a side, away from the second substrate, of the plurality of initial sub-pixel light-emitting functional layers and the initial common cathode layer of the initial chip wafer unit, include: forming a gallium nitride buffer layer, an n-type gallium nitride layer, a quantum well layer and a p-type gallium nitride layer on the side of the second substrate sequentially, and patterning the quantum well layer and the p-type gallium nitride layer to form a quantum well layer and a p-type gallium nitride layer of the initial chip wafer unit;
forming a first insulating layer on a side of the p-type gallium nitride layer away from the quantum well layer, the first insulating layer being provided therein with a plurality of via holes; forming a fourth initial metal sub-layer and a fifth initial metal sub-layer on a side of the first insulating layer away from the second substrate, where the plurality of via holes provided in the first insulating layer are filled with the fourth initial metal sub-layer, and the fifth initial metal sub-layer includes a plurality of second-type metal protrusions; and
providing the temporary substrate; forming a sixth initial metal sub-layer of the initial chip wafer unit on a side of the temporary substrate; and bonding the sixth initial metal sub-layer, the fifth initial metal sub-layer and the fourth initial metal sub-layer to form a second bonding layer, the second bonding layer including a fourth metal sub-layer, a fifth metal sub-layer and a sixth metal sub-layer, where the fifth metal sub-layer is arranged as a eutectic alloy layer connecting the sixth metal sub-layer and the fourth metal sub-layer.

After a step of peeling off the second substrate, the steps further include the following steps: removing the gallium nitride buffer layer, and patterning the n-type gallium nitride layer and the first insulating layer; and forming the first initial metal sub-layer and the second initial metal sub-layer on a side, away from the temporary substrate, of the n-type gallium nitride layer of each initial chip wafer unit, and roughening a surface of the n-type gallium nitride layer to form the initial chip wafer unit.

Alternatively, after the step of peeling off the second substrate, the steps further include the following steps: patterning the gallium nitride buffer layer, the n-type gallium nitride layer and the first insulating layer; and forming the first initial metal sub-layer and the second initial metal sub-layer on the gallium nitride buffer layer of the initial chip wafer unit, and roughening a surface of the gallium nitride buffer layer to form the initial chip wafer unit.

A step of peeling off the temporary substrate to form a chip wafer unit, includes: forming a second insulating layer on a side of each second bonding layer away from the color conversion layer substrate unit, the second insulating layer is provided therein with a plurality of via holes; forming electrodes, the electrodes including a cathode electrode and anode electrodes, where the cathode electrode and the anode electrodes each fill a corresponding via hole of the plurality of via holes in the second insulating layer; and thinning the first substrate to form a chip wafer.

In some embodiments, steps of forming the initial chip wafer unit on a side of the second substrate, the initial chip wafer unit including a plurality of initial sub-pixel light-emitting functional layers and an initial common cathode layer, and forming the temporary substrate on a side, away from the second substrate, of the plurality of initial sub-pixel light-emitting functional layers and the initial common cathode layer of the initial chip wafer unit, include: forming a gallium nitride buffer layer, an n-type gallium nitride layer, a quantum well layer and a p-type gallium nitride layer on the side of the second substrate sequentially, and patterning the quantum well layer and the p-type gallium nitride layer to form a quantum well layer and a p-type gallium nitride layer of the initial chip wafer unit; and
forming a cathode metal of the initial common cathode layer; forming a second insulating layer on a side, away from the color conversion layer substrate unit, of the p-type gallium nitride layer and the cathode metal, the second insulating layer being provided therein with a plurality of via holes; forming electrodes, the electrodes including a cathode electrode and anode electrodes, and the cathode electrode and the anode electrodes each fill a corresponding via hole of the plurality of via holes in the second insulating layer; and forming the plurality of initial sub-pixel light-emitting functional layers and the initial common cathode layer of the initial chip wafer unit; and bonding the plurality of sub-pixel light-emitting functional layers and the initial common cathode layer on the temporary substrate.

After the step of peeling off the second substrate, the steps further include the following steps: patterning the gallium nitride buffer layer, the n-type gallium nitride layer and the second insulating layer, forming the first initial metal sub-layer and the second initial metal sub-layer on the gallium nitride buffer layer, and roughening a surface of the gallium nitride buffer layer to form the initial chip wafer unit.

In yet another aspect, a display device is provided, which includes the display substrate as described above.

### BRIEF DESCRIPTION OF THE DRAWINGS

In order to describe technical solutions in the present disclosure more clearly, accompanying drawings to be used in some embodiments of the present disclosure will be introduced briefly below. Obviously, the accompanying drawings to be described below are merely accompanying drawings of some embodiments of the present disclosure, and a person of ordinary skill in the art may obtain other drawings according to these drawings. In addition, the accompanying drawings to be described below may be regarded as schematic diagrams, and are not limitations on an actual size of a product, an actual process of a method and actual timings of signals to which the embodiments of the present disclosure relate.
FIG. 1 is a structural diagram of a display structure, in accordance with some embodiments of the present disclosure;
FIG. 2 is a structural diagram of the first initial wafer sheet A, in accordance with some embodiments of the present disclosure;
FIG. 3 is a structural diagram of the second initial wafer sheet B, in accordance with some embodiments of the present disclosure;
FIG. 4 is a structural diagram of a chip structure, in accordance with some embodiments of the present disclosure;
FIG. 5 is a structural diagram of another chip structure, in accordance with some embodiments of the present disclosure;
FIG. 6a is a structural diagram of yet another chip structure, in accordance with some embodiments of the present disclosure;
FIG. 6b is a structural diagram of yet another chip structure, in accordance with some embodiments of the present disclosure;
FIG. 7 is a flow chart of a manufacturing method for an initial chip wafer unit, in accordance with some embodiments of the present disclosure;
FIG. 8 to FIG. 10 are diagrams showing steps of the manufacturing method for the initial chip wafer unit, in accordance with some embodiments of the present disclosure;
FIG. 11 is a flow chart of a metal wafer bonding technology, in accordance with some embodiments of the present disclosure;
FIG. 12 is a diagram showing a step of the metal wafer bonding technology, in accordance with some embodiments of the present disclosure;
FIG. 13 to FIG. 16b are diagrams showing steps of the manufacturing method for the initial chip wafer unit, in accordance with some embodiments of the present disclosure;
FIG. 17 is a flow chart of a manufacturing method for an initial color conversion layer substrate unit, in accordance with some embodiments of the present disclosure;
FIG. 18a to FIG. 22b are diagrams showing steps of the manufacturing method for the initial color conversion layer substrate unit, in accordance with some embodiments of the present disclosure;
FIG. 23 is a flow chart of a cell-assembling process in a chip manufacturing method, in accordance with some embodiments of the present disclosure;
FIG. 24 to FIG. 28 are diagrams showing steps of the cell-assembling process in the chip manufacturing method, in accordance with some embodiments of the present disclosure;
FIG. 29 is a flow chart of a manufacturing method for another initial chip wafer unit, in accordance with some embodiments of the present disclosure;
FIG. 30 to FIG. 32 are diagrams showing steps of the manufacturing method for the another initial chip wafer unit, in accordance with some embodiments of the present disclosure;
FIG. 33 is a flow chart of a manufacturing method for yet another initial chip wafer unit, in accordance with some embodiments of the present disclosure;
FIG. 34 to FIG. 41 are diagrams showing steps of the manufacturing method for the yet another initial chip wafer unit, in accordance with some embodiments of the present disclosure;
FIG. 42 is a flow chart of another cell-assembling process in a chip manufacturing method, in accordance with some embodiments of the present disclosure;
FIG. 43 is a diagram showing a step of the another cell-assembling process in the chip manufacturing method, in accordance with some embodiments of the present disclosure; and
FIG. 44 is a structural diagram of a display device, in accordance with some embodiments of the present disclosure.

### DETAILED DESCRIPTION

Technical solutions in some embodiments of the present disclosure will be described clearly and completely with reference to the accompanying drawings below. Obviously, the described embodiments are merely some but not all embodiments of the present disclosure. All other embodiments obtained by a person having ordinary skill in the art based on the embodiments of the present disclosure shall be included in the protection scope of the present disclosure.

Unless the context requires otherwise, throughout the description and the claims, the term "comprise" and other forms thereof such as the third-person singular form "comprises" and the present participle form "comprising" are construed in an open and inclusive meaning, i.e., "including, but not limited to". In the description of the specification, the terms such as "one embodiment," "some embodiments," "exemplary embodiments," "example," "specific example" or "some examples" are intended to indicate that specific features, structures, materials or characteristics related to the embodiment(s) or example(s) are included in at least one embodiment or example of the present disclosure. Schematic representations of the above term do not necessarily refer to the same embodiment(s) or example(s). In addition, specific features, structures, materials or characteristics may be included in any one or more embodiments or examples in any suitable manner.

Hereinafter, the terms such as "first" and "second" are used for descriptive purposes only, but are not to be construed as indicating or implying the relative importance or implicitly indicating the number of indicated technical features. Thus, the features defined with "first" and "second" may explicitly or implicitly include one or more of the features. In the description of the embodiments of the present disclosure, the term "a (the) plurality of" mean two or more unless otherwise specified.

In the description of some embodiments, the terms "coupled", "connected" and derivatives thereof may be used. For example, the term "connected" may be used in the description of some embodiments to indicate that two or more components are in direct physical or electrical contact with each other. For another example, the term "coupled" may be used in the description of some embodiments to indicate that two or more components are in direct physical or electrical contact. However, the term "coupled" or "communicatively coupled" may also mean that two or more components are not in direct contact with each other, but still cooperate or interact with each other. The embodiments disclosed herein are not necessarily limited to the contents herein.

The phrase "at least one of A, B and C" has a same meaning as the phrase "at least one of A, B or C", and they both include the following combinations of A, B and C: only A, only B, only C, a combination of A and B, a combination of A and C, a combination of B and C, and a combination of A, B and C.

The phrase "A and/or B" includes the following three combinations: only A, only B, and a combination of A and B.

As used herein, the term "if" is optionally construed as "when" or "in a case where" or "in response to determining" or "in response to detecting", depending on the context. Similarly, depending on the context, the phrase "if it is determined ..." or "if [a stated condition or event] is detected" is optionally construed as "in a case where it is determined ...", "in response to determining ...", "in a case where [the stated condition or event] is detected" or "in response to detecting [the stated condition or event]".

As used herein, the term such as "about", "substantially" or "approximately" includes a stated value and an average value within an acceptable range of deviation of a particular value. The acceptable range of deviation is determined by a person of ordinary skill in the art in view of measurement in question and errors associated with measurement of a particular quantity (i.e., limitations of a measurement system).

As used herein, "parallel", "perpendicular" and "equal" include the stated conditions and the conditions similar to the stated conditions, and the range of the similar conditions is within the acceptable deviation range, where the acceptable deviation range is determined by a person of ordinary skill in the art in consideration of the measurement in question and the error associated with the measurement of a specific quantity (i.e., the limitation of the measurement system). For example, the term "parallel" includes absolute parallelism and approximate parallelism, and an acceptable range of deviation of the approximate parallelism may be, for example, a deviation within 5°; the term "perpendicular" includes absolute perpendicularity and approximate perpendicularity, and an acceptable range of deviation of the approximate perpendicularity may also be, for example, a deviation within 5°. The term "equal" includes absolute equality and approximate equality, and an acceptable range of deviation of the approximate equality may be, for example, a difference between two equals of less than or equal to 5% of either of the two equals.

It will be understood that, in a case where a layer or component is referred to as being on another layer or a substrate, it may be that the layer or component is directly on the another layer or substrate; or it may be that intermediate layer(s) exist between the layer or component and the another layer or substrate.

Exemplary embodiments are described herein with reference to sectional views and/or plan views as idealized exemplary drawings. In the accompanying drawings, thicknesses of layers and regions are enlarged for clarity. Therefore, variations in shapes with respect to the accompanying drawings due to, for example, manufacturing technologies and/or tolerances may be envisaged. Therefore, the exemplary embodiments should not be construed as being limited to the shapes of the regions shown herein, but including shape deviations due to, for example, manufacturing. For example, an etched region shown in a rectangular shape generally has a curved feature. Therefore, the regions shown in the accompanying drawings are schematic in nature, and their shapes are not intended to show actual shapes of regions in a device, and are not intended to limit the scope of the exemplary embodiments.

The current red light Micro-LEDs (Micrometer-sized Light-emitting Diodes) are mostly made of AlGaInP (Aluminum Gallium Indium Phosphide, red light semiconductor) material, and their efficiency may reach more than 60% under a normal chip size. However, as the chip size is reduced to the micrometer scale, the efficiency will decrease to below 1%. In addition, in a process of mass transfer, disadvantages of the AlGaInP material are also quite obvious. Mass transfer requires materials to have good mechanical strength to avoid cracking during chip handling and placement. However, a poor mechanical performance of the AlGaInP material will increase the difficulty of mass transfer.

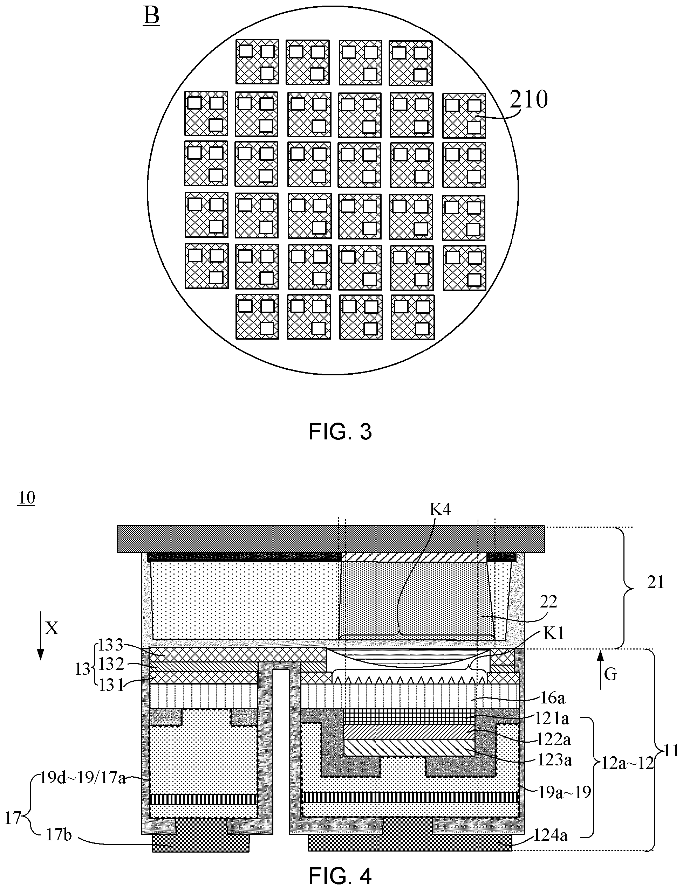

In light of this, the present disclosure provides a chip structure 10. As shown in FIG. 4 to FIG. 6b, the chip structure 10 includes a chip wafer unit 11 and a color conversion layer substrate unit 21 arranged on a light-exit side G of the chip wafer unit 11. The chip wafer unit 11 includes a plurality of sub-pixel light-emitting functional layers 12. The color conversion layer substrate unit 21 includes a color conversion layer 22 arranged on the light-exit side G of the chip wafer unit 11. The chip wafer unit 11 further includes a first bonding layer 13, arranged between the sub-pixel light-emitting functional layers 12 and the color conversion layer 22 and configured to bond the chip wafer unit 11 and the color conversion layer substrate unit 21.

As shown in FIG. 4 to FIG. 6b, the chip structure 10 includes the chip wafer unit 11 and the color conversion layer substrate unit 21, a sub-pixel light-emitting functional layer 12 of the plurality of sub-pixel light-emitting functional layers 12 in the chip wafer unit 11 is configured to emit light of one of a plurality of colors, and the plurality of sub-pixel light-emitting functional layers 12 may be configured to emit light of a same color. The color conversion layer substrate unit 21 is arranged on the light-exit side G of the chip wafer unit 11, and on a light-exit side G of each sub-pixel light-emitting functional layer 12, the sub-pixel light-emitting functional layer 12 is provided with a corresponding color conversion layer 22 in the color conversion layer structure unit 21.

In the present disclosure, the chip wafer unit 11 and the color conversion layer substrate unit 21 are connected through a metal wafer bonding effect of the first bonding layer 13, the first bonding layer 13 is made of metal materials, the metal materials have high refractive indexes, light emitted by the sub-pixel light-emitting functional layers 12 can be prevented from light leakage and being cross-colored, and the light-emitting effect of the chip structure 10 is improved.

The chip wafer unit 11 and the color conversion layer substrate unit 21 are connected through the metal wafer bonding effect of the first bonding layer 13, and the manufacturing method includes: forming an initial chip wafer unit 110 and an initial color conversion layer substrate unit 210, and bonding the initial chip wafer unit 110 and the initial color conversion layer substrate unit 210 through a metal wafer bonding technology to form the chip structure 10. To illustrate the technical solution more clearly, three embodiments are provided below.

It will be noted that for clarity, the manufacturing method for the chip structure 10 is described below by taking a single chip structure 10 as an example. It can be understood that the manufacturing method for the chip structure 10 is a method in which a wafer including a plurality of chip structures 10 arranged in an array is formed first, and then a single chip structure 10 is formed by cutting the wafer.

A first embodiment (Embodiment 1) of a manufacturing method for a chip structure 10 is described below, according to which the formed chip structure 10 is shown in FIG. 4.

### Embodiment 1

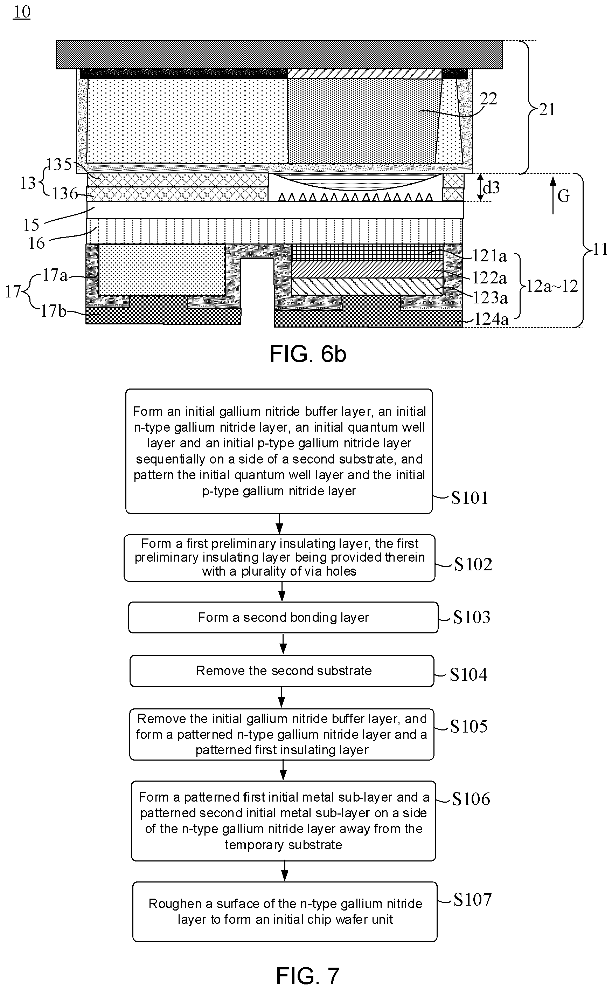

Specifically, as shown in FIG. 7, steps for manufacturing the initial chip wafer unit 110 include steps S101 to S107.

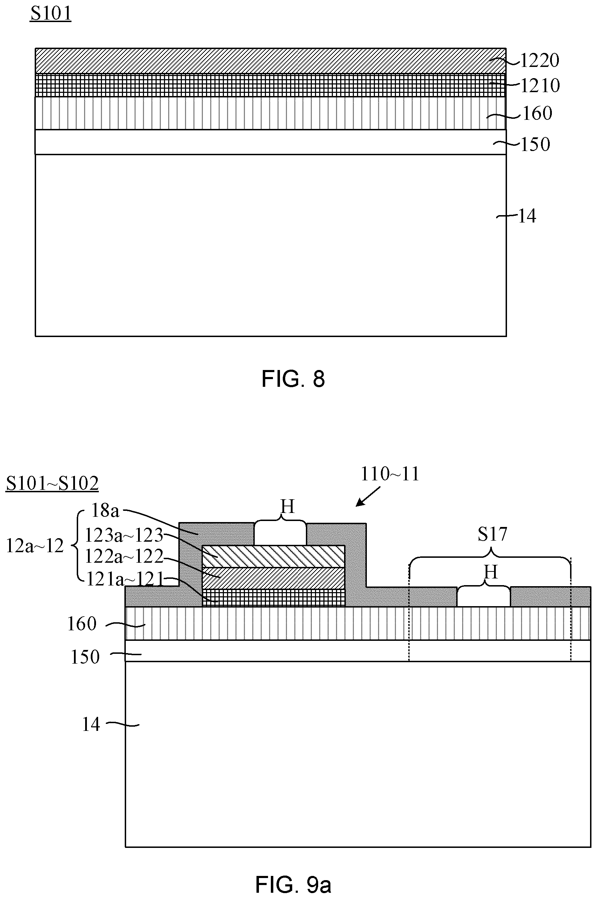

**In** step S101, as shown in FIG. 8 and FIG. 9a, an initial gallium nitride buffer layer 150, an initial n-type gallium nitride layer 160, an initial quantum well layer 1210 and an initial p-type gallium nitride layer 1220 are sequentially formed on a side of a second substrate 14, and the initial quantum well layer 1210 and the initial p-type gallium nitride layer 1220 are patterned to form a quantum well layer 121 and a p-type gallium nitride layer 122 in the initial chip wafer unit 110.

For example, the second substrate 14 may be a sapphire substrate or a silicon-based substrate.

For example, the quantum well layer 121 may be a blue quantum well layer, and sub-pixel light-emitting functional layers 12 formed by the blue quantum well layer emits blue light.

For example, the initial quantum well layer 1210 and the initial p-type gallium nitride layer 1220 are patterned by a photolithography process, so the initial quantum well layer 1210 and the initial p-type gallium nitride layer 1220 in regions each between adjacent sub-pixel light-emitting functional layers 12 and in a negative electrode region S17 are removed, where the description of the negative electrode region S17 refers to the subsequent contents specifically, and is not repeated here.

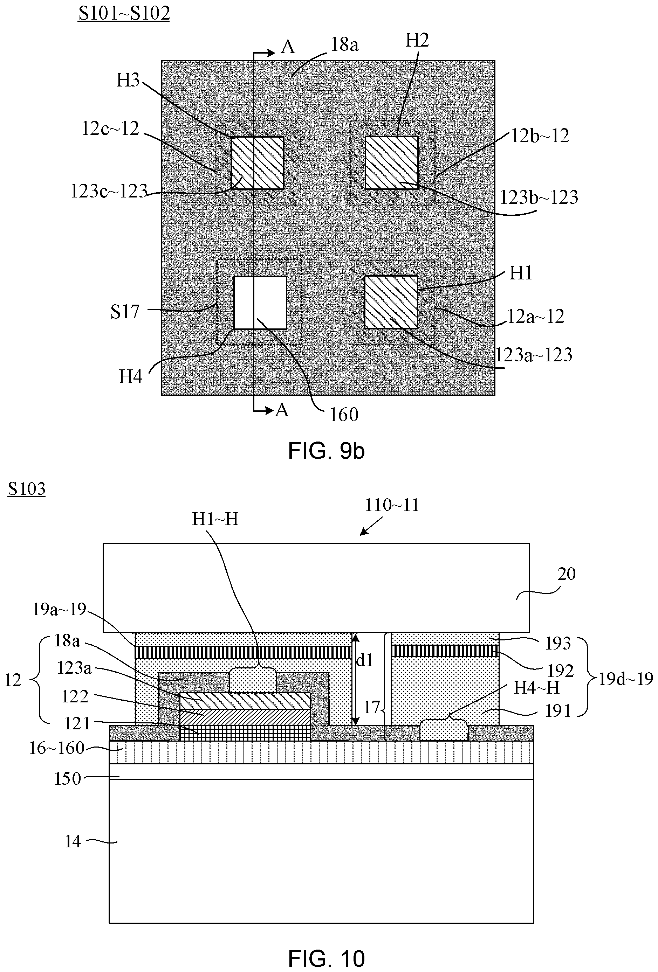

In some examples, as shown in FIG. 9a and FIG. 9b, the plurality of sub-pixel light-emitting functional layers 12 of the chip wafer unit 11 include a first sub-pixel light-emitting functional layer 12a, a second sub-pixel light-emitting functional layer 12b, and a third sub-pixel light-emitting functional layer 12c. In this step, a first quantum well 121a and a first p-type gallium nitride 122a in the first sub-pixel light-emitting functional layer 12a are formed, a second quantum well and a second p-type gallium nitride in the second sub-pixel light-emitting functional layer 12B are formed, and a third quantum well and a third p-type gallium nitride in the third sub-pixel light-emitting functional layer 12c are formed. FIG. 9a is a cross-sectional view taken along the section line AA in FIG. 9b.

In some examples, as shown in FIG. 9a, an initial reflective metal layer is further stacked on a side of the p-type gallium nitride layer 122 away from the second substrate 14, and the initial reflective metal layer is patterned to form a reflective metal layer 123 of each initial chip wafer unit 110 of a plurality of initial chip wafer units 110.

For example, the initial reflective metal layer is deposited by a deposition process.

For example, ITO-Ag-ITO (Indium Tin Oxide-Silver-Indium Tin Oxide) may be used as a material of the reflective metal layer 123, and the reflective metal layer 123 has a function of reflecting light, so as to improve the light output efficiency of the sub-pixel light-emitting functional layers 12.

For example, as shown in FIG. 9b, the reflective metal layer 123 includes a first reflective portion 123a, a second reflective portion 123b, and a third reflective portion 123c. The first sub-pixel light-emitting functional layer 12a includes the first reflective portion 123a, the second sub-pixel light-emitting functional layer 12b includes the second reflective portion 123b, and the third sub-pixel light-emitting functional layer 12c includes the third reflective portion 123c.

In step S102, as shown in FIG. 9a and FIG. 9b, a first preliminary insulating layer 18a is formed, and the first preliminary insulating layer 18a is provided therein with a plurality of via holes H.

For example, a first initial insulating layer is formed on a side of the reflective metal layer 123 and the initial n-type gallium nitride layer 160 away from the second substrate 14 by a deposition process, and the plurality of via holes H are formed in the first initial insulating layer by a photolithography process to form the first preliminary insulating layer 18a. As shown in FIG. 9b, the plurality of via holes H includes a first via hole H1, a second via hole H2, a third via hole H3, and a fourth via hole H4. The first via hole H1 corresponds to the first sub-pixel light-emitting functional layer 12a, the second via hole H2 corresponds to the second sub-pixel light-emitting functional layer 12b, the third via hole H3 corresponds to the third sub-pixel light-emitting functional layer 12c, and the fourth via hole H4 corresponds to the negative electrode region S17.

In step S103, as shown in FIG. 10, a second bonding layer 19 is formed.

A portion of the second bonding layer 19 is formed as a common cathode layer 17 and the second bonding layer 19 further has the function of bonding a temporary substrate 20 of the initial chip wafer unit 110.

For example, the temporary substrate 20 is a silicon substrate.

For example, the second bonding layer 19 may be formed using a metal wafer bonding technology. The metal wafer bonding technology refers to a technology of completely bonding two different metals at a temperature lower than their respective melting points by forming a eutectic alloy between the metals. The metal wafer bonding technology can be divided into a solid-liquid interdiffusion bonding technology and a solid diffusion bonding technology according to different bonding temperatures. The requirement of the solid-liquid interdiffusion bonding technology on the flatness of a film layer is less than that of the solid-state diffusion bonding technology. And the solid-liquid interdiffusion bonding technology has high bonding strength and short bonding time. Therefore, the second bonding layer 19 may be formed using the solid-liquid interdiffusion bonding technology.

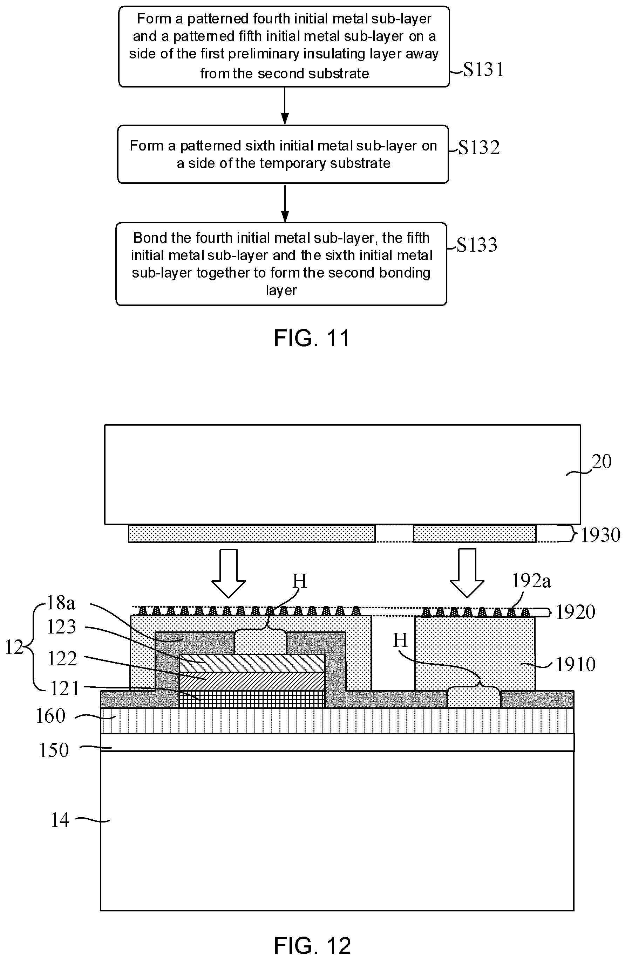

Steps for forming the second bonding layer 19 are shown in FIG. 11 and include steps S131 to S133.

In step S131, as shown in FIG. 12, a patterned fourth initial metal sub-layer 1910 and a patterned fifth initial metal sub-layer 1920 are formed on a side of the first preliminary insulating layer 18a away from the second substrate 14.

The fourth initial metal sub-layer 1910 fills the plurality of via holes H arranged in the first preliminary insulating layer 18a, and the fifth initial metal sub-layer 1920 includes a plurality of second-type metal protrusions 192a.

It will be noted that in the present disclosure, "forming a patterned film layer" means that an initial film layer provided as a whole layer is formed first, and then a patterning process (e.g., a photolithography process) is performed on the initial film layer to from the patterned film layer, so that the film layer has a specific pattern. Related descriptions appearing subsequently all adopt the above explanation. For example, an entire layer of a material for forming the fourth initial metal sub-layer 1910 is deposited on a side of the first preliminary insulating layer 18a away from the second substrate 14 through a deposition process, and the patterned fourth initial metal sub-layer 1910 is formed by a photolithography process. The material of the fourth initial metal sub-layer 1910 may adopt any one of Au (Gold), Ag (Silver), Pb (Plumbum), Sn (Stannum) and Cu (Copper).

For example, the second-type metal protrusions 192a of the fifth initial metal sub-layer 1920 may have a cylindrical or conical structure. During the process of forming the second bonding layer 19, the second-type metal protrusions become liquid, and form a eutectic alloy layer with the fourth initial metal sub-layer 1910 adjacent to and a sixth initial metal sub-layer 1930 formed subsequently.

A material of the fifth initial metal sub-layer 1920 may be In (Indium). A temperature at which Au (Gold) and In (Indium) form a eutectic alloy is 160 °C, a temperature at which Ag (Silver) and In (Indium) form a eutectic alloy is 180 °C, a temperature at which Pb (Plumbum) and In (Indium) form a eutectic alloy is 200 °C, and a temperature at which Sn (Stannum) and In (Indium) form a eutectic alloy is 120 °C.

In addition, the material of the fifth initial metal sub-layer 1920 may be Sn (Stannum). A temperature at which Cu (Copper) and Sn (Stannum) form a eutectic alloy is 280 °C, a temperature at which Au (Gold) and Sn (Stannum) form a eutectic alloy at 280 °C, and a temperature at which Ag (Silver) and Sn (Stannum) form a eutectic alloy at 250 °C.

It will be noted that the above description does not limit the material of the fifth initial metal sub-layer 1920, as long as the eutectic alloy formed by the material of the fourth initial metal sub-layer 1910 and the material of the fifth initial metal sub-layer 1920 has a melting temperature of less than 400 °C.

For example, the fifth initial metal sub-layer 1920 is formed by a lift-off process. For example, an array of inverted trapezoid protrusion structures is first formed on the fourth initial metal sub-layer 1910 by using a photoresist, and then the material (In or Sn) for forming the fifth initial metal sub-layer 1920 is evaporated to form the fifth initial metal sub-layer 1920 with the second-type metal protrusions 192a.

In step S132, as shown in FIG. 12, a patterned sixth initial metal sub-layer 1930 is formed on a side of the temporary substrate 20.

For example, an entire layer of a material for forming the sixth initial metal sub-layer 1930 is deposited on the side of the temporary substrate 20 through a deposition process, and the patterned sixth initial metal sub-layer 1930 is formed by a photolithography process. The material of the sixth initial metal sub-layer 1930 may adopt any one of Au (Gold), Ag (Silver), Pb (Plumbum), Sn (Stannum) and Cu (Copper). And, the material of the sixth initial metal sub-layer 1930 may be the same as the material of the fourth initial metal sub-layer 1910.

In step S133, as shown in FIG. 12, the fourth initial metal sub-layer 1910, the fifth initial metal sub-layer 1920 and the sixth initial metal sub-layer 1930 are bonded together to form the second bonding layer 19.

As shown in FIG. 10, the second bonding layer 19 includes a fourth metal sub-layer 191, a fifth metal sub-layer 192, and a sixth metal sub-layer 193 that are stacked, and the fifth metal sub-layer 192 is a eutectic alloy layer connecting the fourth metal sub-layer 191 and the sixth metal sub-layer 193, thereby achieving the purpose of connecting the temporary substrate 20 to the initial chip wafer unit 110.

For example, the bonding of the fourth metal sub-layer 191, the fifth metal sub-layer 192 and the sixth metal sub-layer 193 that are included in the second bonding layer 19 is realized by a solid-liquid interdiffusion bonding technology, and the descriptions on the introduction of the solid-liquid interdiffusion bonding technology are given above, and are not repeated here.

For example, as shown in FIG. 10, the second bonding layer 19 includes a first bonding portion 19a, a second bonding portion, a third bonding portion, and a fourth bonding portion 19d. A cathode metal 17a of the common cathode layer 17 includes the fourth bonding portion 19d. That is, a portion of the second bonding layer 19 located in the negative electrode region S17 shown in FIG. 9a is the fourth bonding portion 19d.

As shown in FIG. 9a, FIG. 9b and FIG. 10, the fourth metal sub-layer 191 of the first bonding portion 19a fills the first via hole H1 to connect to the first reflective portion 123a, the fourth metal sub-layer 191 of the second bonding portion fills the second via hole H2 to connect to the second reflective portion 123b, the fourth metal sub-layer layer 191 of the third bonding portion fills the third via hole H3 to connect to the third reflective portion 123c, and the fourth metal sub-layer 191 of the fourth bonding portion 19d fills the fourth via hole H4 to connect to the initial n-type gallium nitride layer 160. Positions of the first, second, third and fourth via holes H1, H2, H3, H4, and the first, second and third reflective portions 123a, 123b, 123c are shown in FIG. 9b.

For example, as shown in FIG. 10, a thickness d1 of the second bonding layer 19 may be in a range of 3 µm to 6 µm, inclusive. For example, the thickness d1 of the second bonding layer 19 is 3 µm, 4 µm, 5 µm, or 6 µm, but is not limited thereto.

After the formation of the initial chip wafer unit 110 provided with the temporary substrate 20 through the second bonding layer 19, the following steps are performed.

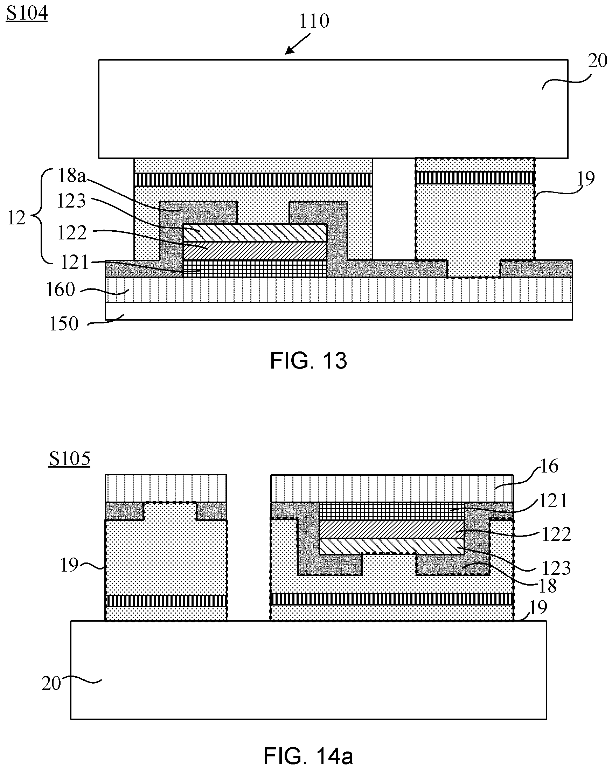

In step S104, the second substrate 14 is removed. A structure of an initial chip wafer unit 110 after the second substrate 14 is removed is shown in FIG. 13.

For example, the temporary substrate 20 is protected by an acid-resistant film or wax seal, the initial chip wafer unit 110 is placed in an etching tank containing hydrofluoric acid (HF), and the second substrate 14 is removed by etching.

In step S105, the initial gallium nitride buffer layer 150 is removed, and a patterned n-type gallium nitride layer 16 and a patterned first insulating layer 18 are formed, the structure of which is shown in FIG. 14a.

For example, the initial n-type gallium nitride layer 160 is patterned by a photolithographic process to form the patterned n-type gallium nitride layer 16. The first preliminary insulating layer 18a is patterned by a photolithography process to form the patterned first insulating layer 18.

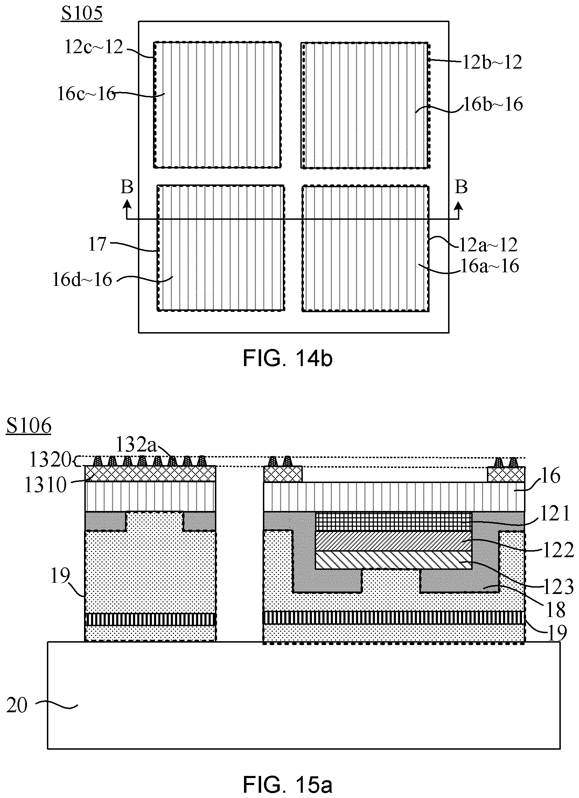

For example, as shown in FIG. 14b, the n-type gallium nitride layer 16 includes a first n-type gallium nitride 16a, a second n-type gallium nitride 16b, a third n-type gallium nitride 16c, and a fourth n-type gallium nitride 16d. The first n-type gallium nitride 16a is arranged corresponding to the first sub-pixel light-emitting functional layer 12a, the second n-type gallium nitride 16b is arranged corresponding to the second sub-pixel light-emitting functional layer 12b, the third n-type gallium nitride 16c is arranged corresponding to the third sub-pixel light-emitting functional layer 12c, and the fourth n-type gallium nitride 16d is arranged corresponding to the common cathode layer 17. FIG. 14a is a cross-sectional view taken along the section line BB in FIG. 14b.

In step S106, as shown in FIG. 15a, a patterned first initial metal sub-layer 1310 and a patterned second initial metal sub-layer 1320 are formed on a side of the n-type gallium nitride layer 16 away from the temporary substrate 20.

The first initial metal sub-layer 1310 and the second initial metal sub-layer 1320 are used to form the first bonding layer 13 for bonding the chip wafer unit 11 and the color conversion layer substrate unit 21, which will be described later.

For example, an entire layer of a material for forming the first initial metal sub-layer 1310 is deposited on the side of the n-type gallium nitride layer 16 away from the temporary substrate 20 through a deposition process, and the patterned first initial metal sub-layer 1310 is formed by a photolithography process. The material of the first initial metal sub-layer 1310 may adopt any one of Au (Gold), Ag (Silver), Pb (Plumbum), and Sn (Stannum).

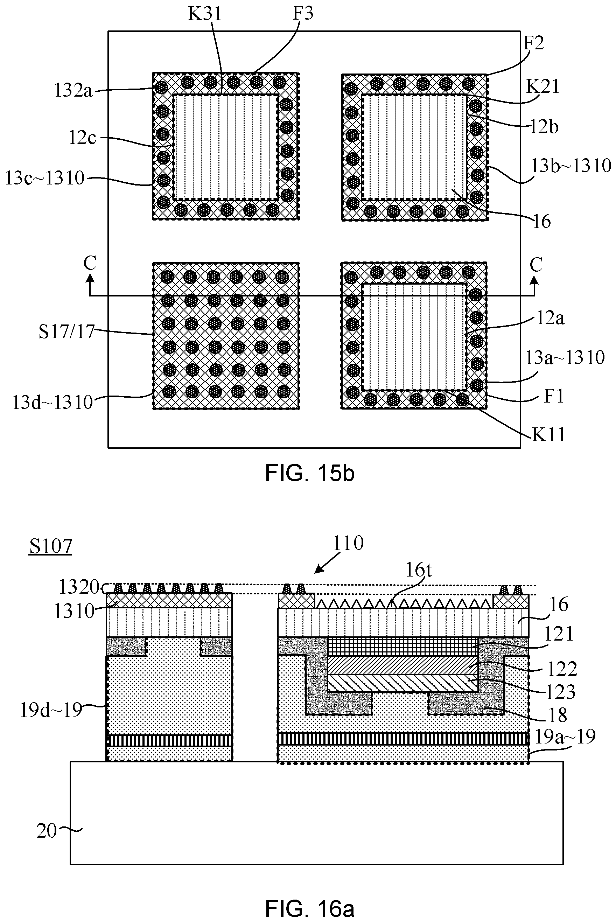

As shown in FIG. 15b, the patterned first initial metal sub-layer 1310 includes a first zone 13a, a second zone 13b, a third zone 13c, and a fourth zone 13d, and the first zone 13a, the second zone 13b, the third zone 13c, and the fourth zone 13d are separately arranged. The first sub-pixel light-emitting functional layer 12a is located in a first light-emitting region F1, and the first zone 13a is arranged corresponding to the first light-emitting region F1; the second sub-pixel light-emitting functional layer 12b is located in a second light-emitting region F2, and the second zone 13b is arranged corresponding to the second light-emitting region F2; the third sub-pixel light-emitting functional layer 12c is located in a third light-emitting region F3, and the third zone 13c is arranged corresponding to the third light-emitting region F3; and the common cathode layer 17 is located in the negative electrode region S17, and the fourth zone 13d is arranged corresponding to the negative electrode region S17. FIG. 15a is a cross-sectional view taken along the section line CC in FIG. 15b.

Of the first initial metal sub-layer 1310, the first zone 13a includes the first sub-opening area K11, the second zone 13b includes the second sub-opening area K21, and the third zone 13c includes the third sub-opening area K31.

For example, the second initial metal sub-layer 1320 includes a plurality of first-type metal protrusions 132a, and the first-type metal protrusions 132a may have a cylindrical or conical.

A material of the second initial metal sub-layer 1320 may be In (Indium). A temperature at which Au (Gold) and In (Indium) form a eutectic alloy is 160 °C, a temperature at which Ag (Silver) and In (Indium) form a eutectic alloy is 180 °C, a temperature at which Pb (Plumbum) and In (Indium) form a eutectic alloy is 200 °C, and a temperature at which Sn (Stannum) and In (Indium) form a eutectic alloy is 120 °C.

It will be noted that the above is not a limitation on the material of the second initial metal sub-layer 1320. In a case where the eutectic alloy layer is formed between the first initial metal sub-layer 1310 and the second initial metal sub-layer 1320, the melting temperature of forming the eutectic alloy is needed to be less than 240 °C. If the melting temperature of the eutectic alloy layer is too high, it will cause damage to the color conversion layer 22 in the color conversion layer substrate unit 21.

For example, the formation process of the second initial metal sub-layer 1320 may refer to the formation process of the fifth initial metal sub-layer 1920, and details thereof are not repeated herein.

In step S107, as shown in FIG. 16a, a surface of the n-type gallium nitride layer 16 is roughened to form an initial chip wafer unit 110.

For example, the surface of the n-type gallium nitride layer 16 is roughened by using a strong alkali at 70 °C to 80 °C, so that a plurality of second-type micro-protrusion structures 16t are formed on the exposed surface of the n-type gallium nitride layer 16. The second-type micro-protrusion structures 16t can make light easily exit, and improve the light output efficiency of the chip structure 10.

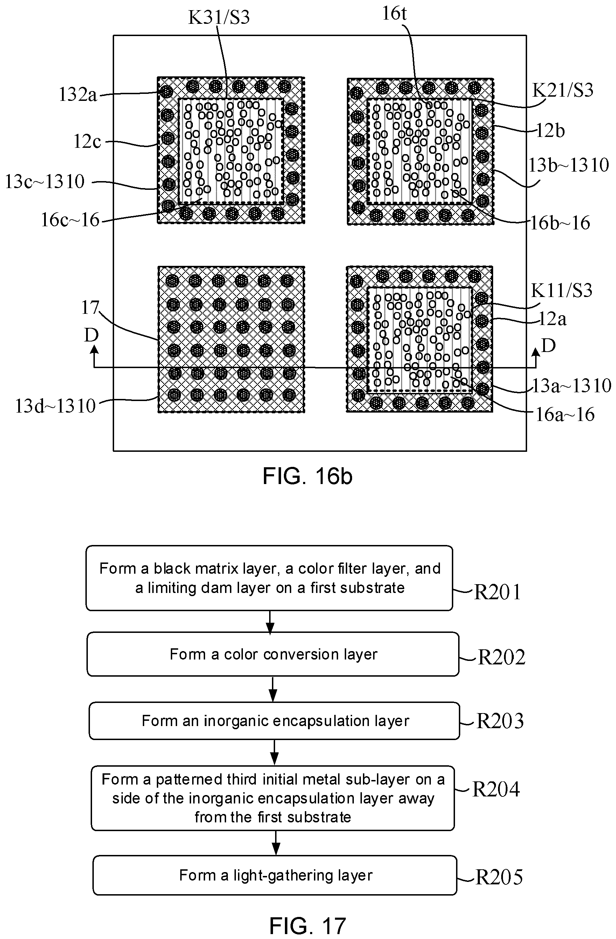

As shown in FIG. 16b, the first zone 13a of the first initial metal sub-layer 1310 includes the first sub-opening area K11, the second zone 13b includes the second sub-opening area K21, and the third zone 13c includes the third sub-opening area K31. Due to the action of the strong alkali, the plurality of second-type micro-protrusion structures 16t are formed on a surface of the first n-type gallium nitride 16a exposed by the first sub-opening area K11, on a surface of the second n-type gallium nitride 16b exposed by the second sub-opening area K21, and on a surface of the third n-type gallium nitride 16c exposed by the third sub-opening area K31. FIG. 16a is a cross-sectional view taken along the section line DD in FIG. 16b.

A region, corresponding to the first sub-pixel light-emitting functional layer 12a, the second sub-pixel light-emitting functional layer 12b and the third sub-pixel light-emitting functional layer 12c, of the n-type gallium nitride layer 16 is a third region S3. That is, the third region S3 is the region of the n-type gallium nitride layer 16 exposed in this step to correspond to the first sub-opening area K11, the second sub-opening area K21 and the third sub-opening area K31.

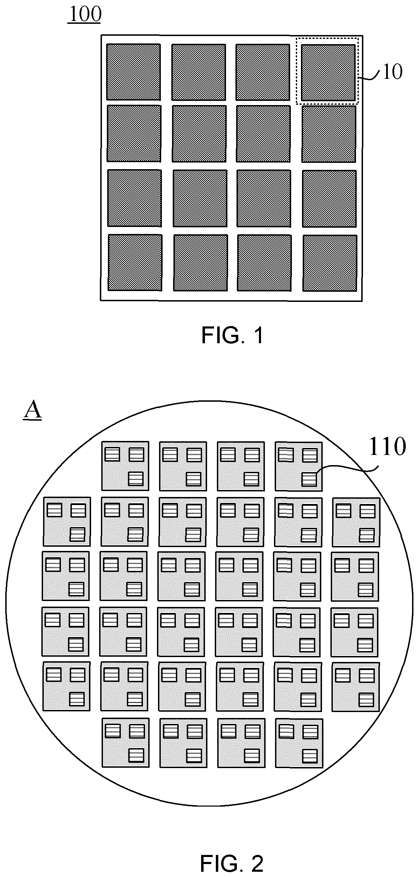

During a process of manufacturing the initial chip wafer unit 110, a large plate including a plurality of initial chip wafer units 110 arranged in an array is formed at one time. The large plate is cut, for example, by a special-shaped cutting, to form a plurality of first initial wafer sheets A. As shown in FIG. 2, a first initial wafer sheet A has a circular shape, and the first initial wafer sheet A includes a plurality of initial chip wafer units 110. For example, the first wafer sheet A has a size of 4 inches or 6 inches.

Steps of manufacturing the initial color conversion layer substrate unit 210 will be described in the following. As shown in FIG. 17, the steps include steps R201 to R205.

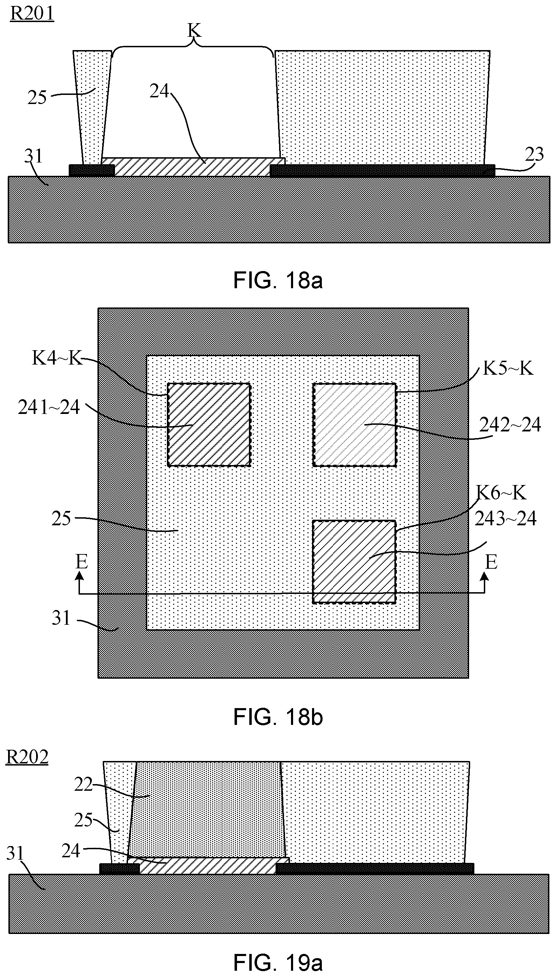

In step R201, as shown in FIG. 18a, a black matrix layer 23, a color filter layer 24, and a limiting dam layer 25 are formed on a first substrate 31.

For example, the first substrate 31 may be a glass substrate.

For example, the black matrix layer 23 and a plurality of color filter layers 24 defined by the black matrix layer 23 are formed by coating, exposing, developing, post-baking, and the like. As shown in FIG. 18b, the plurality of color filter layers 24 include a first light-filtering film 241, a second light-filtering film 242 and a third light-filtering film 243. For example, the first light-filtering film 241 is a red light-filtering film, the second light-filtering film 242 is a green light-filtering film, and the third light-filtering film 243 is a blue light-filtering film. FIG. 18a is a cross-sectional view taken along the section line EE in FIG. 18b.

For example, as shown in FIG. 18a, the limiting dam layer 25 is formed on a side of the black matrix layer 23 away from the first substrate 31 by coating, exposing, developing, post-baking, and the like, and a plurality of opening area K are defined in the limiting dam layer 25. For example, as shown in FIG. 18b, the plurality of opening area K include a fourth opening area K4, a fifth opening area K5 and a sixth opening area K6.

In step R202, as shown in FIG. 19a, a color conversion layer 22 is formed.

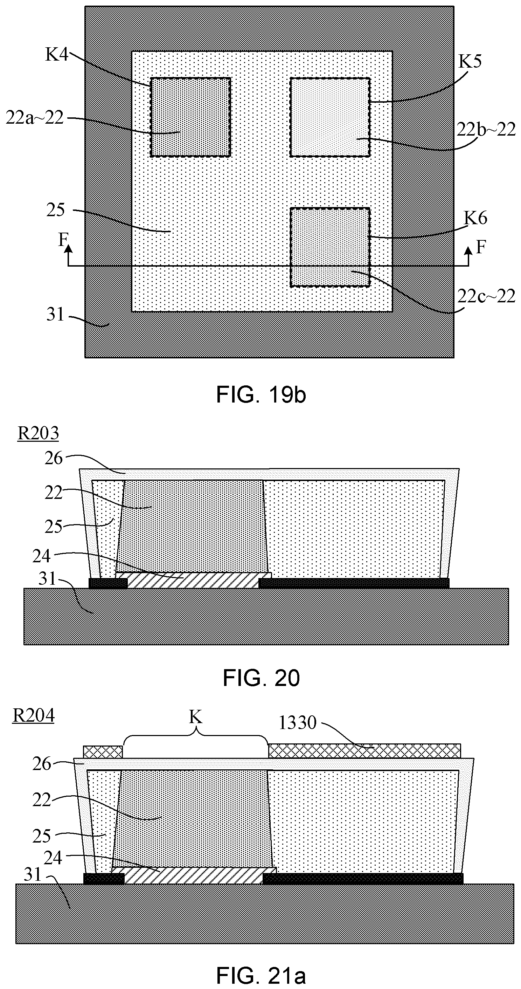

For example, as shown in FIG. 19b, the color conversion layer 22 is formed in the fourth opening area K4, the fifth opening area K5 and the sixth opening area K6 by coating, exposing, developing, and post-baking, or by ink-jet printing. A first quantum dot conversion part 22a is formed in the fourth opening area K4, and the first quantum dot conversion part 22a is made of a red quantum dot light-emitting material; a scattering particle part 22b is formed in the fifth opening area K5, and the scattering particle part 22b is made of scattering particles; the third quantum dot conversion part 22c is formed in the sixth opening area K6, and the third quantum dot conversion part 22c is made of a green quantum dot light-emitting material. FIG. 19a is a cross-sectional view taken along the section line FF in FIG. 19b.

Further, as shown in FIG. 4 and FIG. 19b in combination, an orthographic projection of the fourth opening area K4 on the color conversion layer substrate unit 2 covers an orthographic projection of the first sub-pixel light-emitting functional layer 12a on the color conversion layer substrate unit 2.

Similarly, an orthographic projection of the fifth opening area K5 on the color conversion layer substrate unit 2 covers an orthographic projection of the second sub-pixel light-emitting functional layer 12b on the color conversion layer substrate unit 2, and an orthographic projection of the sixth opening area K6 on the color conversion layer substrate unit 2 covers an orthographic projection of the third sub-pixel light-emitting functional layer 12c on the color conversion layer substrate unit 2. This arrangement can improve the light output effect of the chip structure 10.

In step R203, as shown in FIG. 20, an inorganic encapsulation layer 26 is formed.

For example, the inorganic encapsulation layer 26 is deposited by CVD (Chemical Vapor Deposition) on a side of the color conversion layer 22 away from the first substrate 31, and the inorganic encapsulation layer 26 covers the color conversion layer 22 and the limiting dam layer 25.

In step R204, as shown in FIG. 21a, a patterned third initial metal sub-layer 1330 is formed on a side of the inorganic encapsulation layer 26 away from the first substrate 31.

For example, an entire layer of a material for forming the third initial metal sub-layer 1330 is deposited on the side of the inorganic encapsulation layer 26 away from the first substrate 31 through a deposition process, and the patterned third initial metal sub-layer 1330 is formed by a photolithography process. The material of the third initial metal sub-layer 1330 may adopt any one of Au (Gold), Ag (Silver), Pb (Plumbum) and Sn (Stannum). And, the material of the third initial metal sub-layer 1330 may be the same as the material of the first initial metal sub-layer 1310.

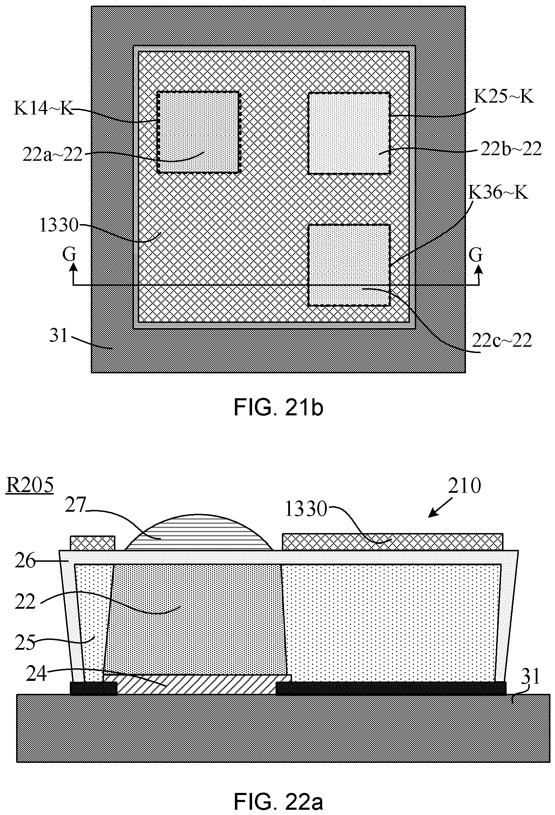

As shown in FIG. 21b, the patterned third initial metal sub-layer 1330 is provided therein with a plurality of opening areas K. For example, as shown in FIG. 21b, the plurality of opening areas K include a fourth sub-opening area K14, a fifth sub-opening area K25 and a sixth sub-opening area K36. The fourth sub-opening region K14 is arranged corresponding to the first quantum dot conversion part 22a, the fifth sub-opening region K25 is arranged corresponding to the scattering particle part 22b, and the sixth sub-opening region K36 is arranged corresponding to the third quantum dot conversion part 22c. FIG. 21a is a cross-sectional view taken along the section line GG in FIG. 21b.

In step R205, as shown in FIG. 22a, a light-gathering layer 27 is formed, so that an initial color conversion layer substrate unit 210 is formed.

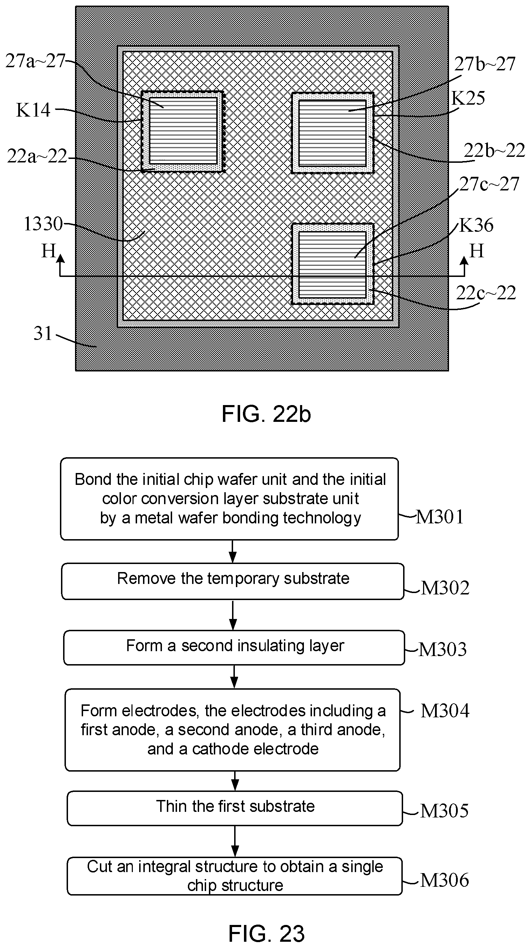

For example, as shown in FIG. 22b, the light-gathering layer 27 includes a first light-gathering portion 27a corresponding to the first quantum dot conversion part 22a, a second light-gathering portion 27b corresponding to the scattering particle part 22b, and a third light-gathering portion 27c corresponding to the third quantum dot conversion part 22c. FIG. 22a is a cross-sectional view taken along the section line HH in FIG. 22b.

A material of the light-gathering layer is an acrylate or epoxy material, and the light-gathering 27 has a light- gathering effect, so that the light output effect of the chip structure 10 may be improved.

During a process of manufacturing the initial color conversion layer substrate unit 210, a large plate including a plurality of initial color conversion layer substrate units 210 arranged in an array is formed at one time. The large plate is cut, for example, by a special-shaped cutting, to form a plurality of second initial wafer sheets B. As shown in FIG. 3, a second initial wafer sheet B has a circular shape, and the second initial wafer sheet B includes a plurality of initial color conversion layer substrate units 210. The second initial wafer sheet B has a same size as the first initial wafer sheet A.

Steps for cell-assembling the first initial wafer sheet A and the second initial wafer sheet B to finally form a single chip structure 10 are described in the following. As shown in FIG. 23, the steps include steps M301 to M306. It will be noted that the following description is given as an example of a formation of a single chip structure 10.

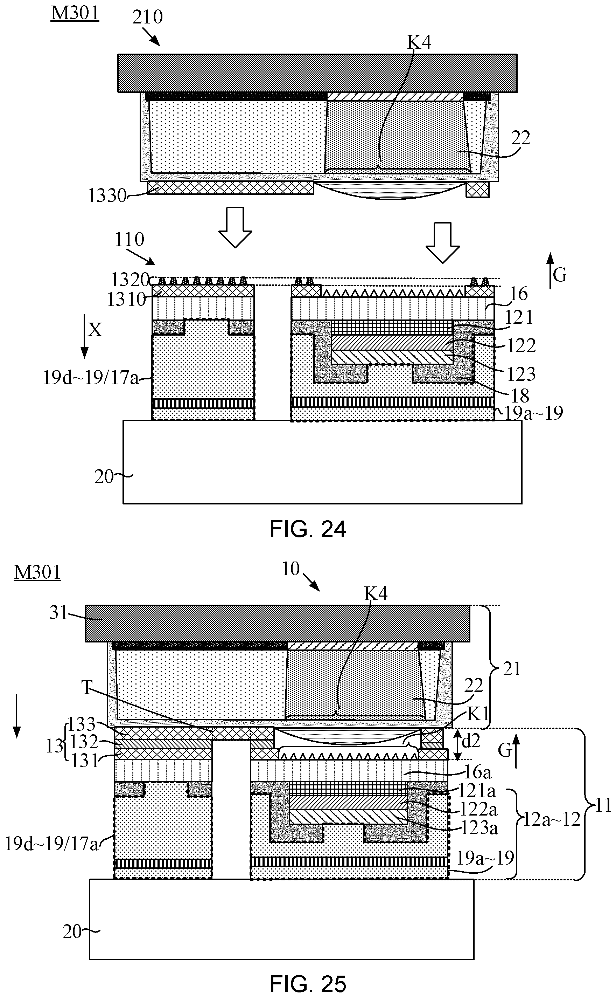

In step M301, as shown in FIG. 24 and FIG. 25, the initial chip wafer unit 110 and the initial color conversion layer substrate unit 210 are bonded by a metal wafer bonding technology. The bonded initial color conversion layer substrate unit 210 forms the color conversion layer substrate unit 21.

As shown in FIG. 24, the initial chip wafer unit 110 and the initial color conversion layer substrate unit 210 are bonded. The first quantum dot conversion part 22a corresponds to the first sub-pixel light-emitting functional layer 12a, the scattering particle part 22b corresponds to the second sub-pixel light-emitting functional layer 12b, and the third quantum dot conversion part 22c corresponds to the third sub-pixel light-emitting functional layer 12c.

In the process of forming the first bonding layer 13, the first-type metal protrusions 132a become liquid, and the second initial metal sub-layer 1320 formed by the structure of the metal protrusions does not enter light-emitting regions when the metal protrusions melt to form liquid, where the light-emitting regions include the first light-emitting region F1, the second light-emitting region F2 and the third light-emitting region F3, so that the first bonding layer 13 is prevented from affecting light emission.

For example, as shown in FIG. 25, the formed first bonding layer 13 includes a first metal sub-layer 131, a second metal sub-layer 132 and a third metal sub-layer 133 that are stacked. A range of a maximum thickness of the first bonding layer 13 is of 3 µm to 6 µm, inclusive. For example, a thickness d2 of the first bonding layer 13 is 3 µm, 4 µm, 5 µm, or 6 µm, which is not limited herein.

It will be noted that, as shown in FIG. 25, in a case where the first bonding layer 13 includes the three layers, i.e., the first metal sub-layer 131, the second metal sub-layer 132 and the third metal sub-layer 133, since the first metal sub-layer 131, the second metal sub-layer 132 and the third metal sub-layer 133 each have a pattern, thicknesses of the first bonding layer 13 at various positions are not equal, for example, in a T region in FIG. 25, the first bonding layer 13 includes only the third metal sub-layer 133. The maximum value of the thickness d2 of the first bonding layer 13 in the present disclosure refers to a thickness at a position where the three metal sub-layers included in the first bonding layer 13 are stacked.

For example, as shown in FIG. 24 and FIG. 25, the third initial metal sub-layer 1330 away from the second initial metal sub-layer 1320 forms the third metal sub-layer 133, and the first initial metal sub-layer 1310 away from the second initial metal sub-layer 1320 forms the first metal sub-layer 131. The third metal sub-layer 133 is closer to the color conversion layer substrate unit 21 than the first metal sub-layer 131. That is, the first metal sub-layer 131 is closer to the light-exit side G of the sub-pixel light-emitting functional layers 12 than the third metal sub-layer 133.

The third initial metal sub-layer 1330 adjacent to the second initial metal sub-layer 1320, and the first initial metal sub-layer 1310 adjacent to the second initial metal sub-layer 1320 form the second metal sub-layer 132, and the second metal sub-layer 132 is provided as a eutectic alloy layer connecting the first metal sub-layer 131 and the third metal sub-layer 133.

In some examples, as shown in FIG. 25, the first bonding layer 13 includes a first opening area K1 corresponding to the first sub-pixel light-emitting functional layer 12a, a second opening area corresponding to the second sub-pixel light-emitting functional layer 12b (not shown in the figure), and a third opening area (not shown in the figure) corresponding to the third sub-pixel light-emitting functional layer 12c (not shown in the figure).

As shown in FIG. 15b, FIG. 21b and FIG. 25, after the first initial metal sub-layer 1310 forms the first bonding layer 13, the first sub-opening area K11, the second sub-opening area K21 and the third sub-opening area K31 of the first initial metal sub-layer 1310 form the first sub-opening area K11, the second sub-opening area K21 and the third sub-opening area K31 of the first metal sub-layer 131, respectively; after the third initial metal sub-layer 1330 forms the first bonding layer 13, the fourth sub-opening area K14, the fifth sub-opening area K25 and the sixth sub-opening area K36 of the third initial metal sub-layer 1330 form the fourth sub-opening area K14, the fifth sub-opening area K25 and the sixth sub-opening area K36 of the third metal sub-layer 133, respectively. The second initial metal sub-layer 1320 forms a eutectic alloy with the first initial metal sub-layer 1310 and the third initial metal sub-layer 1330, and in the process, the second initial metal sub-layer 1320 has no influence on the opening areas of the first initial metal sub-layer 1310 and the third initial metal sub-layer 1330.

That is, after the first initial metal sub-layer 1310, the second initial metal sub-layer 1320, and the third initial metal sub-layer 1330 form the first bonding layer 13, the first sub-opening area K11 and the fourth sub-opening area K14 are stacked to form the first opening area K1 of the first bonding layer 13, the second sub-opening area K21 and the fifth sub-opening area K25 are stacked to form the second opening area of the first bonding layer 13, and the third sub-opening area K31 and the sixth sub-opening area K36 are stacked to form the third opening area of the first bonding layer 13.

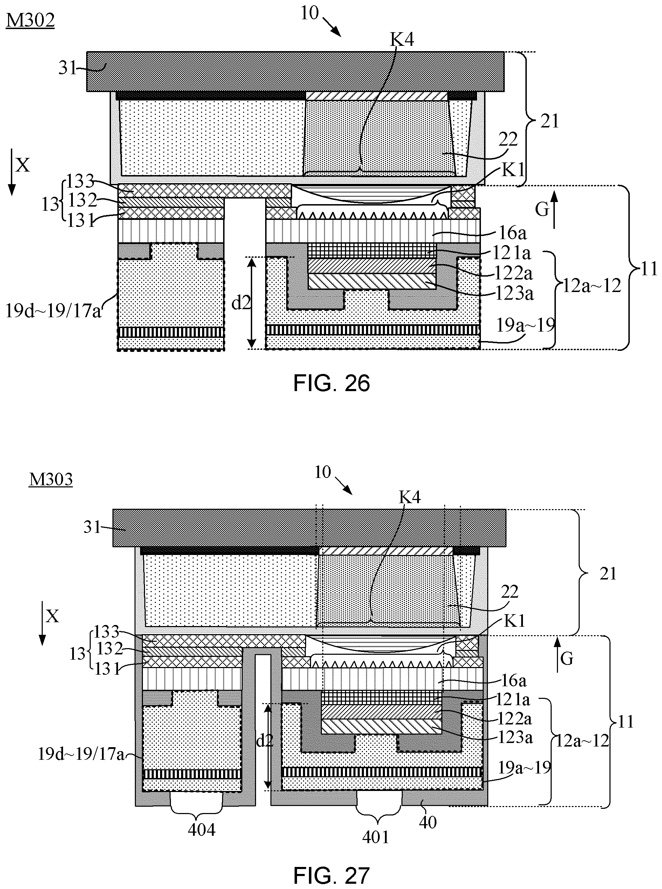

In step M302, the temporary substrate 20 is removed to form a structure as shown in FIG. 26.

For example, the first substrate 31 is protected by an acid-resistant film; the temporary substrate 20 is placed in an etching tank containing hydrofluoric acid (HF), so that a portion of the temporary substrate 20 is etched, and then the remaining portion of the temporary substrate is removed by dry etching.

In step M303, as shown in FIG. 27, a second insulating layer 40 is formed, and the second insulating layer 40 is provided therein with a plurality of via hole.

For example, the via holes in the second insulating layer 40 include a fifth via hole 401, a sixth via hole, a seventh via hole, and an eighth via hole 404, the fifth via hole 401 is arranged corresponding to the first sub-pixel light-emitting functional layer 12a, the sixth via hole is arranged corresponding to the second sub-pixel light-emitting functional layer 12b, the seventh via hole is arranged corresponding to the third sub-pixel light-emitting functional layer 12c, and the eighth via hole 404 is arranged corresponding to the common cathode layer 17.

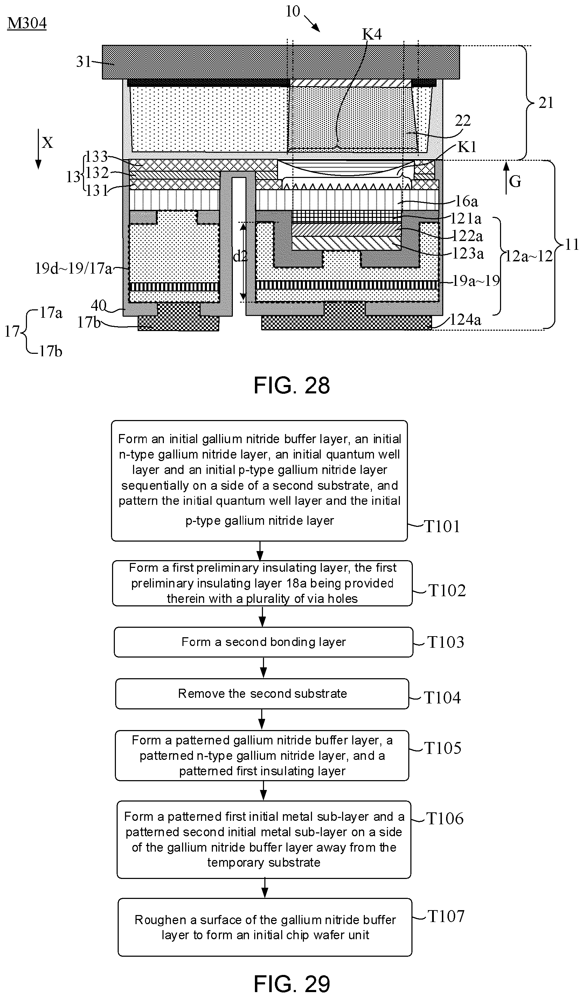

In step M304, as shown in FIG. 28, electrodes are formed, where the electrodes include a first anode 124a, a second anode, a third anode, and a cathode electrode 17b.

Here, the first anode 124a, the second anode, and the third anode are referred to as anode electrodes.

For example, the electrodes are formed by a patterning process. The first anode 124a is arranged corresponding to the first sub-pixel light-emitting functional layer 12a, the second anode is arranged corresponding to the second sub-pixel light-emitting functional layer 12b, the third anode is arranged corresponding to the third sub-pixel light-emitting functional layer 12c, and the cathode electrode 17b and the cathode metal 17a form the common cathode layer 17.

In step M305, the first substrate 31 is thinned.

For example, a thickness of the first substrate 31 is reduced to 60 µm to 200 µm. After the first substrate 31 is thinned, a shape of the formed chip structure 10 is close to a cube, so that the chip structure 10 may be placed more stably, and the use in subsequent processes is facilitated. The use of a thick first substrate 31 during the process of manufacturing the chip structure 10 facilitates the processing of the chip structure 10.

For example, an acid-resistant film is attached to a first surface of the first substrate 31, and then the first substrate 31 is thinned at a second surface, where the plurality of sub-pixel light-emitting functional layers 12 are arranged on the first surface of the first substrate 31.

In step M306, an integral structure formed by bonding the initial chip wafer unit 110 and the initial color conversion layer substrate unit 210 is cut to obtain a single chip structure 10.

In some examples, as shown in FIG. 4, in the chip wafer unit 11, the first sub-pixel light-emitting functional layer 12a includes a first quantum well 121a, a first p-type gallium nitride 122a, a first reflective portion 123a, a first bonding portion 19a and a first anode 124a, which are stacked in a first direction X; the second sub-pixel light-emitting functional layer 12b (not shown in the figure) includes a second quantum well, a second p-type gallium nitride, a second reflective portion 123b, a second bonding portion and a second anode, which are stacked in the first direction X; the third sub-pixel light-emitting functional layer 12c (not shown in the figure) includes a third quantum well, a third p-type gallium nitride, a third reflective portion 123c, a third bonding portion and a third anode, which are stacked in the first direction X; and the common cathode layer 17 includes a cathode metal 17a and a cathode electrode 17b which are stacked in the first direction X. The first direction X is a direction from the color conversion layer substrate unit 2 to the chip wafer unit 1.

The third metal sub-layer 133 is a conductive layer connecting the first n-type gallium nitride 16a, the second n-type gallium nitride 16b, the third n-type gallium nitride 16c and the fourth n-type gallium nitride 16d. That is, the third metal sub-layer 133 has a function of connecting the first sub-pixel light-emitting functional layer 12a, the second sub-pixel light-emitting functional layer 12b, the third sub-pixel light-emitting functional layer 12c and the common cathode layer 17.

The red light external quantum efficiency of the chip structure 10 formed in the above embodiments is improved to 10% to 20%. In the chip structure 10 of these embodiments, the chip wafer unit 11 and the color conversion layer substrate unit 21 are connected through the metal wafer bonding effect of the first bonding layer 13. And, the first bonding layer 13 is made of metal materials, and the metal material has a high refractive index, so that the light emitted from the sub-pixel light-emitting functional layers 12 can be prevented from light leakage and being cross-colored, and the light-emitting effect of the chip structure 10 is improved.

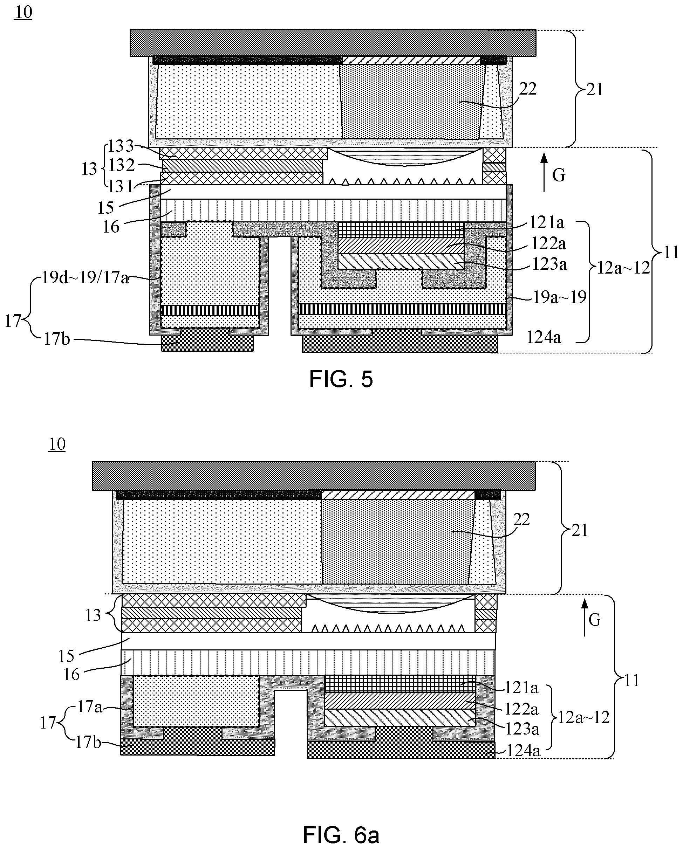

A second embodiment (Embodiment 2) of a manufacturing method for a chip structure 10 is described below, according to which the formed chip structure 10 is shown in FIG. 5.

### Embodiment 2

FIG. 29 shows steps for manufacturing an initial chip wafer unit 110, which includes steps T101 to T107.

In step T101, as shown in FIG. 8 and FIG. 9a, an initial gallium nitride buffer layer 150, an initial n-type gallium nitride layer 160, an initial quantum well layer 1210 and an initial p-type gallium nitride layer 1220 are sequentially formed on a side of a second substrate 14, and the initial quantum well layer 1210 and the initial p-type gallium nitride layer 1220 are patterned to form a quantum well layer 121 and a p-type gallium nitride layer 122 of the initial chip wafer unit 110.

For the specific step, reference may be made to step S101, which is not described herein again.

In step T102, as shown in FIG. 9a and FIG. 9b, a first preliminary insulating layer 18a is formed, and the first preliminary insulating layer 18a is provided therein with a plurality of via holes H.

For the specific step, reference may be made to step S102, which is not described herein again.

In step T103, as shown in FIG. 10, a second bonding layer 19 is formed.

For the specific step, reference may be made to step S103, which is not described herein again.

In step T104, the second substrate 14 is removed. A structure of an initial chip wafer unit 110 after the second substrate 14 is removed is shown in FIG. 13.

For the specific step, refer to step S104, which is not described herein again.

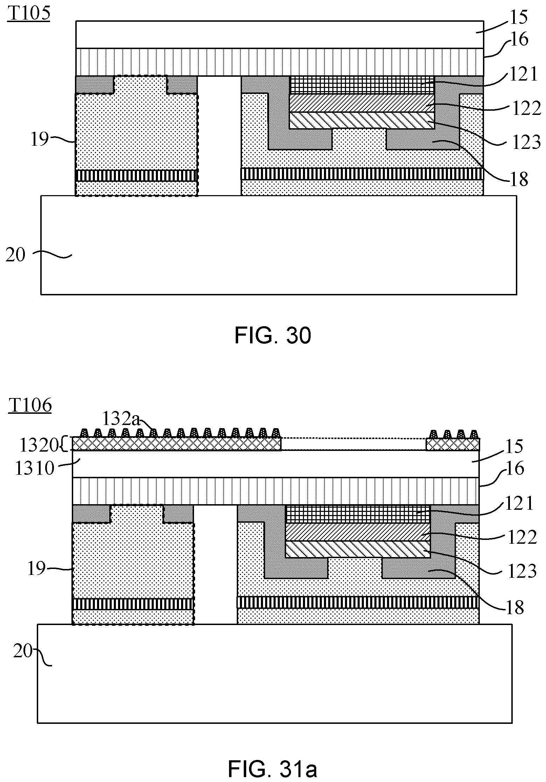

In step T105, as shown in FIG. 30, a patterned gallium nitride buffer layer 15, a patterned n-type gallium nitride layer 16, and a patterned first insulating layer 18 are formed.

For example, the patterned gallium nitride buffer layer 15, the patterned n-type gallium nitride layer 16, and the patterned first insulating layer 18 are formed by processing the initial gallium nitride buffer layer 150, the initial n-type gallium nitride layer 160, and the first initial insulating layer 18a through a photolithography process.

In step T106, as shown in FIG. 31a, a patterned first initial metal sub-layer 1310 and a patterned second initial metal sub-layer 1320 are formed on a side of the gallium nitride buffer layer 15 away from the temporary substrate 20.

The steps for forming the first initial metal sub-layer 1310 and the second initial metal sub-layer 1320 may be referred to as step S106, which are not described herein again.

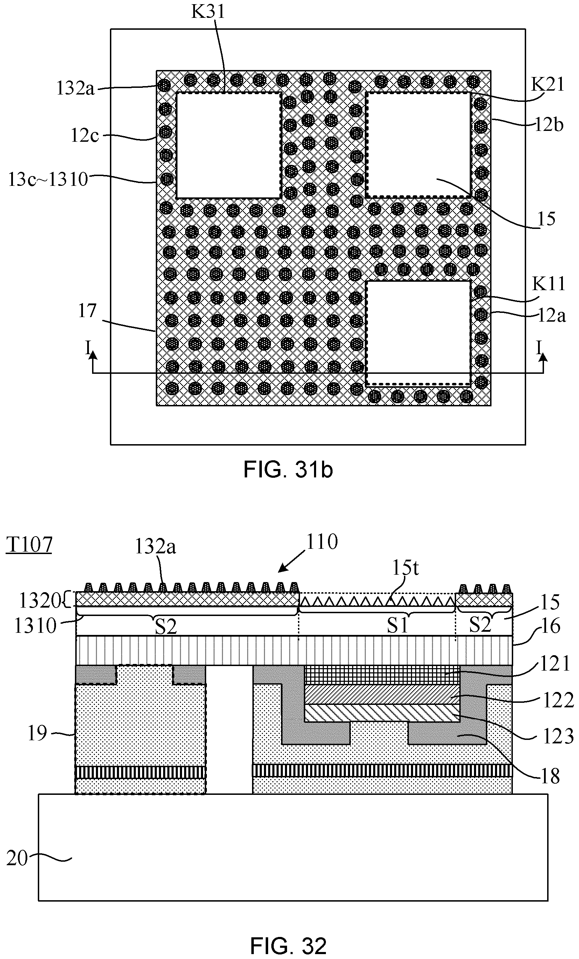

For example, as shown in FIG. 31b, the gallium nitride buffer layer 15 and the n-type gallium nitride layer 16 that are stacked are provided with the first sub-opening area K11, the second sub-opening area K21 and the third sub-opening area K31. The first sub-opening area K11 is arranged corresponding to the first sub-pixel light-emitting functional layer 12a, the second sub-opening area K21 is arranged corresponding to the second sub-pixel light-emitting functional layer 12b, and the third sub-opening area K31 is arranged corresponding to the third sub-pixel light-emitting functional layer 12c. FIG. 31a is a cross-sectional view taken along the section line II in FIG. 31b.

In step T107, as shown in FIG. 32, a surface of the gallium nitride buffer layer 15 is roughened to form an initial chip wafer unit 110.

For example, the surface of the gallium nitride buffer layer 15 is roughened by using a strong alkali at 70 °C to 80 °C, so that a plurality of first-type micro-protrusion structures 15t are formed on the exposed surface of the gallium nitride buffer layer 15. The first-type micro-protrusion structures 15t can make light easily exit, and improve the light output efficiency of the chip structure 10.

Of the gallium nitride buffer layer 15, a region corresponding to the first sub-pixel light-emitting functional layer 12a, the second sub-pixel light-emitting functional layer 12b and the third sub-pixel light-emitting functional layer 12c is a first region S1, and a surface of the first region S1 is the surface of the region of the gallium nitride buffer layer 15 exposed in this step and corresponding to the first sub-opening area K11, the second sub-opening area K21 and the third sub-opening area K31. The plurality of first-type micro-protrusion structures 15t are formed in the surface of the first region S1. The remaining portion of the gallium nitride buffer layer 15 outside the first region S1 is a second region S2, and the first initial metal sub-layer 1310 is formed on a surface of the second region S2 of the gallium nitride buffer layer 15.

The steps for manufacturing the initial color conversion layer substrate unit 210 may be referred to as steps R201 to R205, and details will not be repeated here.

For forming the single chip structure 10 by the cell-assembling process, refer to steps M301 to M306, which are not described herein.

As shown in FIG. 5, the chip structure 10 formed in the above embodiments further includes the n-type gallium nitride layer 16 and the gallium nitride buffer layer 15 that are stacked along a second direction, where the second direction is a direction from the chip wafer unit 11 to the color conversion layer substrate unit 21, and it can be understood that the second direction is parallel to a direction in which the light-exit side G points.

As shown in FIG. 5, the n-type gallium nitride layer 16 is connected to the first quantum well 121a, the second quantum well, the third quantum well, and the cathode metal 17a. That is, the n-type gallium nitride layer 16 has a function of connecting the first sub-pixel light-emitting functional layer 12a, the second sub-pixel light-emitting functional layer 12b, the third sub-pixel light-emitting functional layer 12c, and the common cathode layer 17.

The red light external quantum efficiency of the chip structure 10 formed in the above embodiments is improved to 10% to 20%. In the chip structure 10 of these embodiments, the chip wafer unit 11 and the color conversion layer substrate unit 21 are connected through the metal wafer bonding effect of the first bonding layer 13. And, the first bonding layer 13 is made of metal materials, and the metal material has a high refractive index, so that the light emitted from the sub-pixel light-emitting functional layers 12 can be prevented from light leakage and being cross-colored, and the light-emitting effect of the chip structure 10 is improved. In addition, the first bonding layer 13 in these embodiments has only a connection function, and the n-type gallium nitride layer 16 serves as a conductive layer for connecting the first sub-pixel light-emitting functional layer 12a, the second sub-pixel light-emitting functional layer 12b, the third sub-pixel light-emitting functional layer 12c and the common cathode layer 17, so that the resistance may be reduced.

A third embodiment (Embodiment 3) of a manufacturing method for a chip structure 10 is described below, according to which the formed chip structure 10 is shown in FIG. 6a.

### Embodiment 3

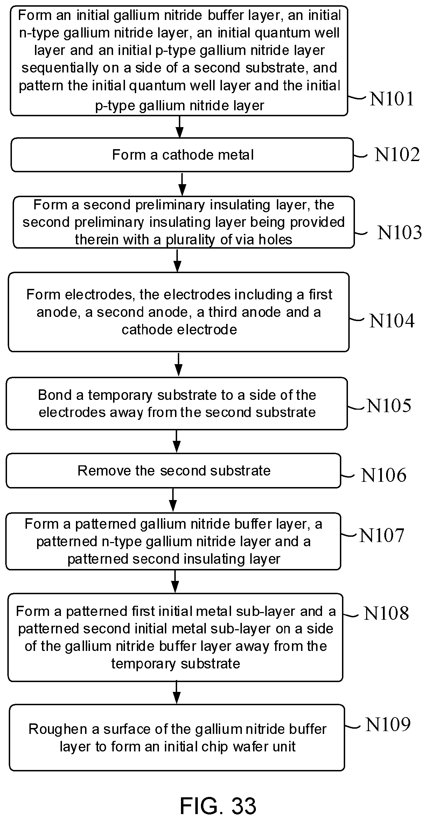

FIG. 33 shows steps for manufacturing an initial chip die unit 110, which include steps N101 to N109.

In step N101, as shown in FIG. 8 and FIG. 9a, an initial gallium nitride buffer layer 150, an initial n-type gallium nitride layer 160, an initial quantum well layer 1210 and an initial p-type gallium nitride layer 1220 are sequentially formed on a side of a second substrate 14, and the initial quantum well layer 1210 and the initial p-type gallium nitride layer 1220 are patterned to form a quantum well layer 121 and a p-type gallium nitride layer 122 of the initial chip wafer unit 110.

For the specific step, reference may be made to step S101, which is not described herein again.

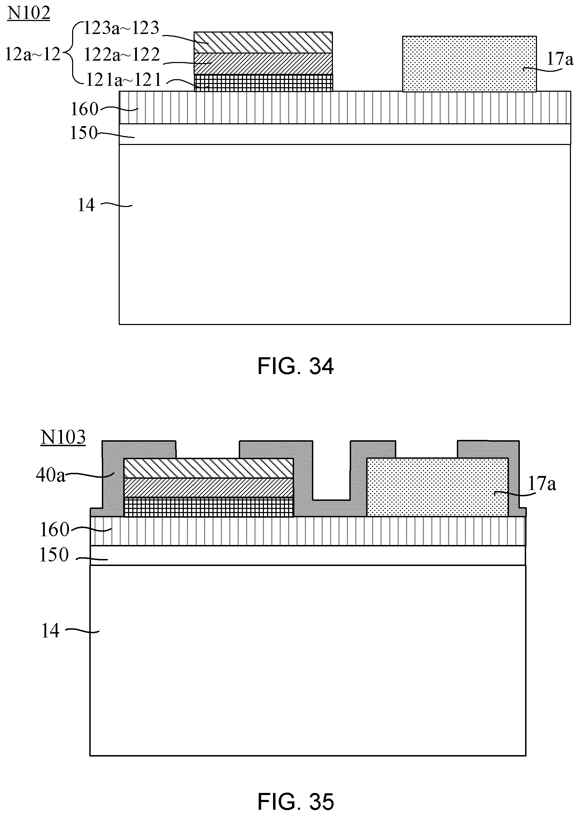

**In** step N102**,** as shown in FIG. 34, a cathode metal 17a is formed.

For example, a patterned photoresist is made by photoresist, a material for forming the cathode metal 17a is evaporated, and the material is patterned to form the cathode metal 17a.

For example, the material of the cathode metal 17a may be any one of titanium, aluminum, nickel and gold.

**In** step N103, as shown in FIG. 35, a second preliminary insulating layer 40a is formed, and the second preliminary insulating layer 40a is provided therein with a plurality of via holes.

For the specific step, reference may be made to the content of step M303, which is not described herein again.

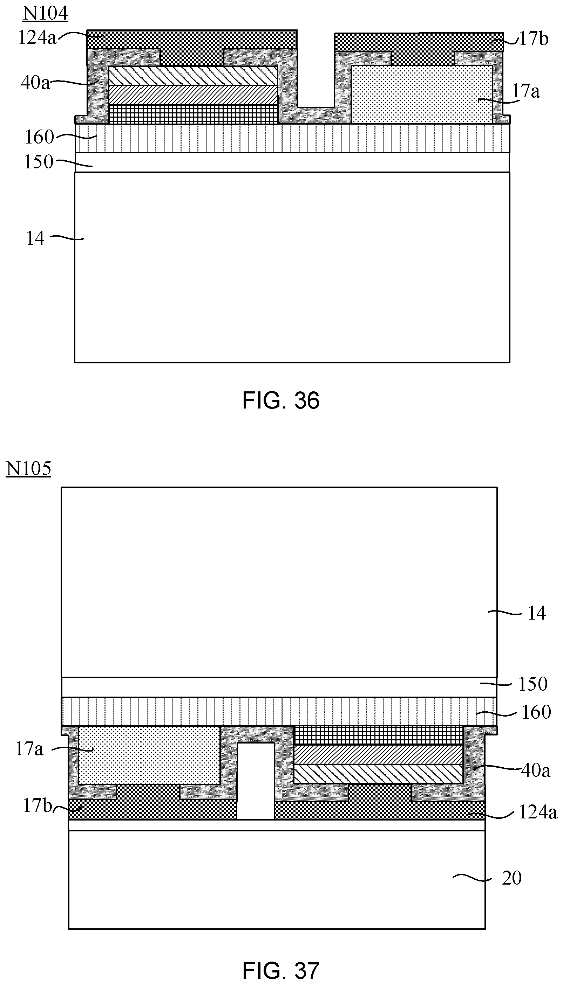

**In** step N104**,** as shown in FIG. 36, electrodes are formed, and the electrodes include a first anode 124a, a second anode, a third anode and a cathode electrode 17b.

For the specific step, reference may be made to the content of step M304, which is not described herein again.

**In** step N105, as shown in FIG. 37, a temporary substrate 20 is bonded to a side of the electrodes away from the second substrate 14.

For example, the temporary substrate 20 is bonded using a temporary bonding adhesive, which may be an acrylate-based thermoplastic adhesive.

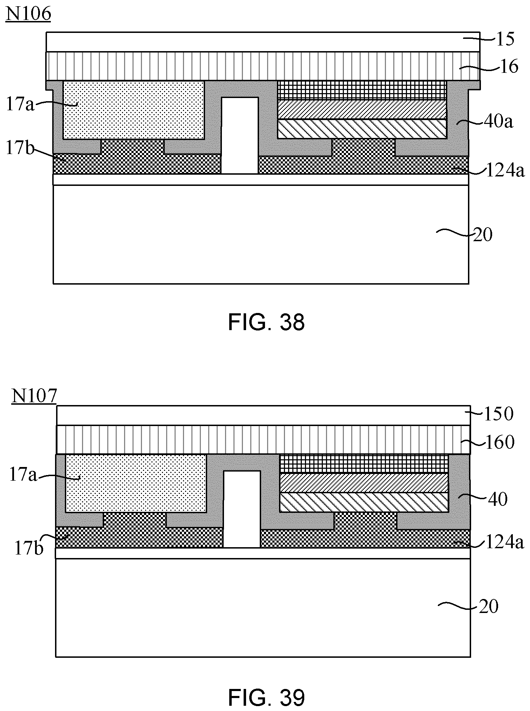

**In** step N106**,** as shown in FIG. 38, the second substrate 14 is removed.

For the specific step, refer to step S104, which is not described herein again.

**In** step N107**,** as shown in FIG. 39, a patterned gallium nitride buffer layer 15, a patterned n-type gallium nitride layer 16 and a patterned second insulating layer 40 are formed.

For example, the patterned gallium nitride buffer layer 15, the patterned n-type gallium nitride layer 16 and the patterned second insulating layer 40 are formed by processing the initial gallium nitride buffer layer 150, the initial n-type gallium nitride layer 160, and the second preliminary insulating layer 40a through a photolithography process.

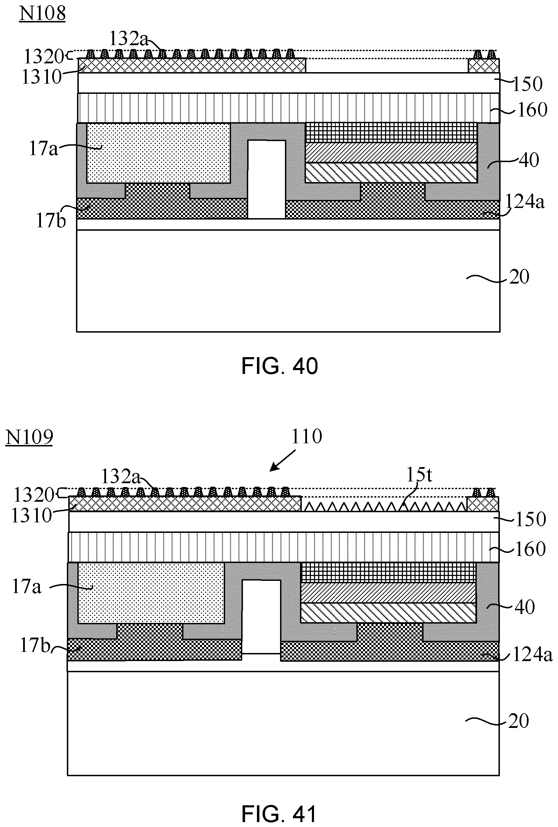

In step N108, as shown in FIG. 40, a patterned first initial metal sub-layer 1310 and a patterned second initial metal sub-layer 1320 are formed on a side of the gallium nitride buffer layer 15 away from the temporary substrate 20.

For the specific step, reference may be made to step T106, which is not described herein again.

In step N109, as shown in FIG. 41, a surface of the gallium nitride buffer layer 15 is roughened to form an initial chip wafer unit 110.

For the specific step, reference may be made to step T107, which is not described herein again.

For the steps for manufacturing the initial color conversion layer substrate unit 210, reference may be made to steps R201 to R205, and details will not be repeated here.

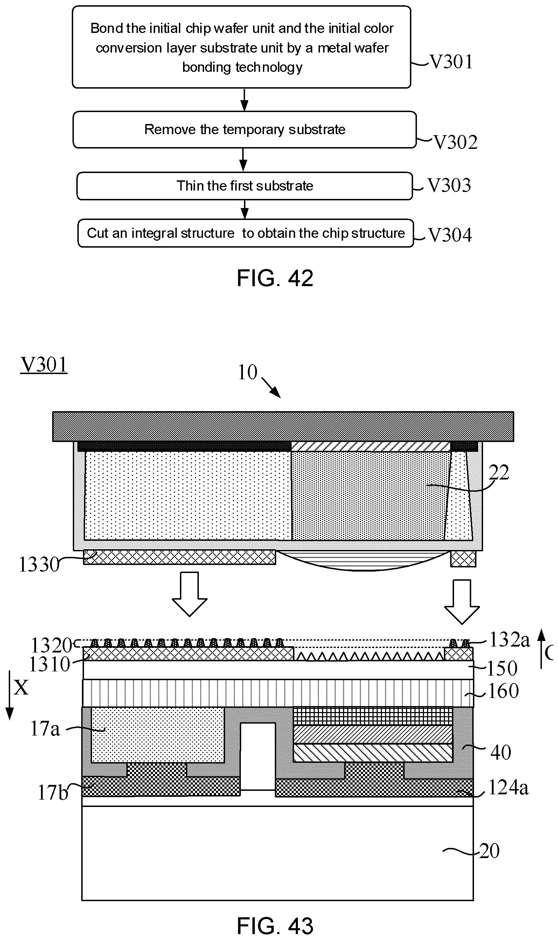

Steps for forming the chip structure 10 by the initial chip wafer unit 110 and the initial color conversion layer substrate unit 210 manufactured in the above steps include steps V301 to V304 as shown in FIG. 42.

In step V301, as shown in FIG. 43, the initial chip wafer unit 110 and the initial color conversion layer substrate unit 210 are bonded by a metal wafer bonding technology.

For the specific step, reference may be made to step M301, which is not described herein again.

In step V302, the temporary substrate 20 is removed.

For example, the temporary bonding adhesive on the temporary substrate 20 is debonded by ultraviolet laser irradiation, and the temporary substrate 20 and the temporary bonding adhesive are removed.

In step V303, the first substrate 31 is thinned.

For the specific step, reference may be made to step M305, which is not described herein again.

In step V304, an integral structure formed by bonding the initial chip wafer unit 110 and the initial color conversion layer substrate unit 210 is cut to obtain the chip structure 10.

For the specific step, reference may be made to step M306, which is not described herein again.

The red light external quantum efficiency of the chip structure 10 formed in the above embodiments is improved to 10% to 20%. In the chip structure 10 of these embodiments, the chip wafer unit 11 and the color conversion layer substrate unit 21 are connected through the metal wafer bonding effect of the first bonding layer 13. And, the first bonding layer 13 is made of metal materials, and the metal material has a high refractive index, so that the light emitted from the sub-pixel light-emitting functional layers 12 can be prevented from light leakage and being cross-colored, and the light-emitting effect of the chip structure 10 is improved. In addition, the first bonding layer 13 in these embodiments has only a connection function, and the n-type gallium nitride layer 16 serves as a conductive layer for connecting the first sub-pixel light-emitting functional layer 12a, the second sub-pixel light-emitting functional layer 12b, the third sub-pixel light-emitting functional layer 12c and the common cathode layer 17, so that the resistance may be reduced.

In some embodiments, as shown in FIG. 6b, the first bonding layer 13 includes a first bonding sub-layer 135 and a second bonding sub-layer 136 that are stacked.

For example, a material of the first bonding sub-layer 135 and the second bonding sub-layer 136 is indium zinc oxide.

For example, a thickness d3 of the first bonding layer 13 formed by the first bonding sub-layer 135 and the second bonding sub-layer 136 is in a range of 200 nm to 1200 nm, inclusive. For example, the thickness d3 of the first bonding layer 13 is 200 nm, 400 nm, 600 nm, 800 nm or 1200 nm, which is not limited herein.

Some embodiments of the present disclosure provide a display substrate 100, as shown in FIG. 1, the display substrate 100 includes a plurality of chip structures 10 each according to any one of the above embodiments.

In some embodiments, the display substrate 100 includes a driving backplane, the driving backplane includes a circuit layer, the plurality of chip structures 10 are arranged on the driving backplane, the circuit layer includes, for example, a plurality of pad groups, each pad group includes a plurality of pads separately arranged, and a cathode electrode 17b, a first anode 124a, a second anode and a third anode of each chip structure 10 are each electrically connected to a respective pad of the plurality of pads.

For example, the plurality of chip structures 10 are transferred to the driving backplane by a mass transfer technology.

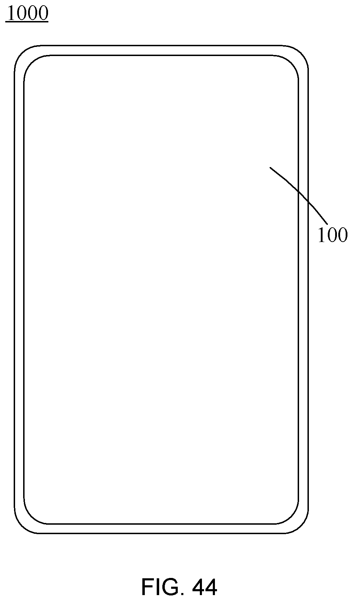

Some embodiments of the present disclosure provide a display device 1000. As shown in FIG. 44, the display device 1000 includes the display substrate 100 described above.

For example, the display apparatus may be any apparatus that can display an image whether in motion (e.g., a video) or stationary (e.g., a static image), and whether literal or graphical. More specifically, it is expected that the embodiments may be implemented in or associated with a plurality of electronic devices. The plurality of electronic devices may include (but is not limit to), for example, mobile telephones, wireless devices, personal data assistants (PDA), hand-held or portable computers, GPS receivers/navigators, cameras, MP4 video players, video cameras, game consoles, watches, clocks, calculators, TV monitors, flat panel displays, computer monitors, car displays (such as odometer displays), navigators, cockpit controllers and/or displays, camera view displays (such as rear view camera displays in vehicles), electronic photos, electronic billboards or indicators, projectors, building structures, packagings and aesthetic structures (such as a display for an image of a piece of jewelry), etc.

The foregoing descriptions are merely specific implementations of the present disclosure, but the protection scope of the present disclosure is not limited thereto. Any changes or replacements that a person skilled in the art could readily conceive of within the technical scope of the present disclosure shall be included in the protection scope of the present disclosure. Therefore, the protection scope of the present disclosure shall be subject to the protection scope of the claims.

## Claims

1. A chip structure, comprising: a chip wafer unit and a color conversion layer substrate unit arranged on a light-exit side of the chip wafer unit, wherein the chip wafer unit includes a plurality of sub-pixel light-emitting functional layers; and the color conversion layer substrate unit includes a color conversion layer arranged on the light-exit side of the chip wafer unit; and
the chip wafer unit further includes a first bonding layer, arranged between the sub-pixel light-emitting functional layers and the color conversion layer, and configured to bond the chip wafer unit and the color conversion layer substrate unit.

2. The chip structure according to claim 1, wherein the first bonding layer includes a first metal sub-layer, a second metal sub-layer and a third metal sub-layer that are stacked, wherein
the third metal sub-layer is closer to the color conversion layer substrate unit than the first metal sub-layer, and the second metal sub-layer is provided as a eutectic alloy layer connecting the first metal sub-layer and the third metal sub-layer; or
the first bonding layer includes a first bonding sub-layer and a second bonding sub-layer that are stacked.

3. The chip structure according to claim 2, wherein a material of the first bonding sub-layer and a material of the second bonding sub-layer are indium zinc oxide.

4. The chip structure according to claim 2 or 3, wherein the chip wafer unit includes a first sub-pixel light-emitting functional layer, a second sub-pixel light-emitting functional layer and a third sub-pixel light-emitting functional layer; and
the first bonding layer includes a first opening area corresponding to the first sub-pixel light-emitting functional layer, a second opening area corresponding to the second sub-pixel light-emitting functional layer and a third opening area corresponding to the third sub-pixel light-emitting functional layer.

5. The chip structure according to claim 4, wherein the chip wafer unit further includes a common cathode layer;
the first sub-pixel light-emitting functional layer includes a first quantum well, a first p-type gallium nitride and a first anode that are stacked along a first direction;
the second sub-pixel light-emitting functional layer includes a second quantum well, a second p-type gallium nitride and a second anode that are stacked along the first direction;
the third sub-pixel light-emitting functional layer includes a third quantum well, a third p-type gallium nitride and a third anode that are stacked along the first direction; and
the common cathode layer includes a cathode metal and a cathode electrode that are stacked along the first direction, wherein
the first direction is a direction from the color conversion layer substrate unit to the chip wafer unit.

6. The chip structure according to claim 5, wherein a material of the cathode metal of the common cathode layer includes any one of titanium, aluminum, nickel and gold.

7. The chip structure according to claim 5, wherein the chip wafer unit further includes a second bonding layer, the second bonding layer including a first bonding portion, a second bonding portion, a third bonding portion and a fourth bonding portion, wherein
the first bonding portion is stacked between the first p-type gallium nitride and the first anode;
the second bonding portion is stacked between the second p-type gallium nitride and the second anode;
the third bonding portion is stacked between the third p-type gallium nitride and the third anode; and
the cathode metal of the common cathode layer includes the fourth bonding portion.

8. The chip structure according to claim 7, wherein the second bonding layer includes a fourth metal sub-layer, a fifth metal sub-layer and a sixth metal sub-layer that are stacked, wherein
the sixth metal sub-layer is farther from the color conversion layer substrate than the fourth metal sub-layer, and the fifth metal sub-layer is provided as a eutectic alloy layer connecting the sixth metal sub-layer and the fourth metal sub-layer.

9. The chip structure according to any one of claims 1 to 8, wherein the chip wafer unit further includes a second bonding layer, wherein
the first bonding layer includes a first metal sub-layer, a second metal sub-layer and a third metal sub-layer that are stacked, and a range of a maximum thickness of the first bonding layer is equal to a range of a thickness of the second bonding layer; or
the first bonding layer includes a first bonding sub-layer and a second bonding sub-layer that are stacked, and a range of a thickness of the first bonding layer is less than a range of a thickness of the second bonding layer.

10. The chip structure according to claim 9, wherein
the first bonding layer includes the first metal sub-layer, the second metal sub-layer and the third metal sub-layer that are stacked, and the range of the maximum thickness of the first bonding layer is of 3 µm to 6 µm, inclusive; or the first bonding layer includes the first bonding sub-layer and the second bonding sub-layer that are stacked, and the range of the thickness of the first bonding layer is of 200 nm to 1200 nm, inclusive; and
the range of the thickness of the second bonding layer is of 3 µm to 6 µm, inclusive.

11. The chip structure according to any one of claims 1 to 10, wherein the first bonding layer includes a first metal sub-layer, a second metal sub-layer and a third metal sub-layer that are stacked, wherein
the second metal sub-layer is a eutectic alloy layer with a melting temperature of less than 240 °C.

12. The chip structure according to any one of claims 6 to 10, wherein the chip wafer unit further includes an n-type gallium nitride conductive layer and a gallium nitride buffer layer that are stacked along a second direction, the second direction being a direction from the chip wafer unit to the color conversion layer substrate unit, wherein
the n-type gallium nitride conductive layer is connected to the first quantum well, the second quantum well, the third quantum well and the cathode metal; and
a region, corresponding to the first sub-pixel light-emitting functional layer, the second sub-pixel light-emitting functional layer and the third sub-pixel light-emitting functional layer, of the gallium nitride buffer layer is a first region, and a side of the first region facing the color conversion layer substrate is provided thereon with a plurality of first-type micro-protrusion structures; a portion of the gallium nitride buffer layer, which does not include the first region, is a second region, and the first bonding layer is located on a side of the gallium nitride buffer layer of the second region facing the color conversion layer substrate.

13. The chip structure according to claim 7 or 8, wherein the chip wafer unit further includes an n-type gallium nitride conductive layer, the n-type gallium nitride conductive layer including a first n-type gallium nitride, a second n-type gallium nitride, a third n-type gallium nitride and a fourth n-type gallium nitride, wherein
the first n-type gallium nitride is stacked on a side of the first quantum well away from the first p-type gallium nitride;
the second n-type gallium nitride is stacked on a side of the second quantum well away from the second p-type gallium nitride;
the third n-type gallium nitride is stacked on a side of the third quantum well away from the third p-type gallium nitride; and
the fourth n-type gallium nitride is stacked on a side of a fourth bonding region facing the color conversion layer substrate; and
the first bonding layer is arranged on a side of the n-type gallium nitride conductive layer facing the color conversion layer substrate unit.

14. The chip structure according to claim 13, wherein the first metal sub-layer and the second metal sub-layer that are stacked include a first zone provided with the first opening area, a second zone provided with the second opening area, a third zone provided with the third opening area and a fourth zone covering the common cathode layer; and
the third metal sub-layer covers the second metal sub-layer of the first zone, the second zone, the third zone and the fourth zone, and is configured as a conductive layer connecting the first n-type gallium nitride, the second n-type gallium nitride, the third n-type gallium nitride and the fourth n-type gallium nitride.

15. The chip structure according to claim 13 or 14, wherein a region, corresponding to the first sub-pixel light-emitting functional layer, the second sub-pixel light-emitting functional layer and the third sub-pixel light-emitting functional layer, of the n-type gallium nitride conductive layer is a third region, and a side of the third region facing the color conversion layer substrate unit is provided thereon with a plurality of second-type micro-protrusion structures.

16. The chip structure according to any one of claims 5 to 8 and 12 to 15, wherein the chip wafer unit further includes a reflective metal layer, the reflective metal layer including a first reflective portion, a second reflective portion and a third reflective portion, wherein
the first reflective portion is stacked between the first p-type gallium nitride and the first anode;
the second reflective portion is stacked between the second p-type gallium nitride and the second anode; and
the third reflective portion is stacked between the third p-type gallium nitride and the third anode.

17. The chip structure according to claim 16, wherein the chip wafer unit includes a second bonding layer, the second bonding layer including a first bonding portion, a second bonding portion, a third bonding portion and a fourth bonding portion, wherein
the first reflective portion is stacked on a side of the first bonding portion facing the color conversion layer substrate unit;
the second reflective portion is stacked on a side of the second bonding portion facing the color conversion layer substrate unit; and
the third reflective portion is stacked on a side of the third bonding portion facing the color conversion layer substrate unit.

18. The chip structure according to claim 17, wherein a side of the second bonding layer facing the color conversion layer substrate unit is provided thereon with an insulating layer, the insulating layer being provided therein with a first via hole, a second via hole, a third via hole and a fourth via hole, wherein
a fourth metal sub-layer of the first bonding portion fills the first via hole and is connected to the first reflective portion;
a fourth metal sub-layer of the second bonding portion fills the second via hole and is connected to the second reflective portion;
a fourth metal sub-layer of the third bonding portion fills the third via hole and is connected to the third reflective portion; and
a fourth metal sub-layer of the fourth bonding portion fills the fourth via hole and is connected to the n-type gallium nitride conductive layer.

19. The chip structure according to any one of claims 1 to 18, wherein the chip wafer unit includes a first sub-pixel light-emitting functional layer, a second sub-pixel light-emitting functional layer and a third sub-pixel light-emitting functional layer; and
the color conversion layer includes a limiting dam layer, and a fourth opening area, a fifth opening area and a sixth opening area that are defined by the limiting dam layer, wherein
the fourth opening area is provided therein with a first quantum dot conversion part corresponding to the first sub-pixel light-emitting functional layer;
the fifth opening area is provided therein with a scattering particle part corresponding to the second sub-pixel light-emitting functional layer; and
the sixth opening area is provided therein with a scattering particle part corresponding to the third sub-pixel light-emitting functional layer.

20. The chip structure according to claim 19, wherein
an orthographic projection of the fourth opening area on the color conversion layer substrate unit covers an orthographic projection of the first sub-pixel light-emitting functional layer on the color conversion layer substrate unit;
an orthographic projection of the fifth opening area on the color conversion layer substrate unit covers an orthographic projection of the second sub-pixel light-emitting functional layer on the color conversion layer substrate unit; and
an orthographic projection of the sixth opening area on the color conversion layer substrate unit covers an orthographic projection of the third sub-pixel light-emitting functional layer on the color conversion layer substrate unit.

21. The chip structure according to claim 19 or 20, wherein the color conversion layer substrate unit further includes a light-gathering layer, the light-gathering layer being arranged on a side of the color conversion layer proximate to the chip wafer unit, wherein
the light-gathering layer includes a first light-gathering portion corresponding to the first quantum dot conversion part, a second light-gathering portion corresponding to the scattering particle part, and a third light-gathering portion corresponding to the third quantum dot conversion part.

22. The chip structure according to any one of claims 19 to 21, wherein the color conversion layer substrate unit further includes a substrate and a color filter layer; and the substrate, the color filter layer and the color conversion layer are stacked along a second direction, the second direction being a direction from the chip wafer unit to the color conversion layer substrate unit, wherein
the color filter layer includes a black matrix, and a first light-filtering film corresponding to the first quantum dot conversion part, a second light-filtering film corresponding to the scattering particle part and a third light-filtering film corresponding to the scattering particle part that are defined by the black matrix.

23. A display substrate, comprising the chip structure according to any one of claims 1 to 22.

24. A chip manufacturing method, comprising:
forming an initial chip wafer unit, the initial chip wafer unit including a temporary substrate, a plurality of sub-pixel light-emitting functional layers, a first initial metal sub-layer and a second initial metal sub-layer that are stacked, wherein the second initial metal sub-layer includes a plurality of first-type metal protrusions;
forming a color conversion layer substrate unit, the color conversion layer substrate unit including a color conversion layer and a first substrate that are stacked;
forming a third initial metal sub-layer on a side of the color conversion layer away from the first substrate;
bonding the first initial metal sub-layer, the second initial metal sub-layer and the third initial metal sub-layer to form a first bonding layer, the first bonding layer including a first metal sub-layer, a second metal sub-layer and a third metal sub-layer, wherein the second metal sub-layer is a eutectic alloy layer connecting the first metal sub-layer and the third metal sub-layer; and
peeling off the temporary substrate to form a chip wafer unit, wherein the chip wafer unit and the color conversion layer substrate unit are connected through the first bonding layer.

25. The chip manufacturing method according to claim 24, wherein a step of forming an initial chip wafer unit, includes:
providing a second substrate;
forming the initial chip wafer unit on a side of the second substrate, the initial chip wafer unit including a plurality of initial sub-pixel light-emitting functional layers and an initial common cathode layer;
forming the temporary substrate on a side, away from the second substrate, of the plurality of initial sub-pixel light-emitting functional layers and the initial common cathode layer of the initial chip wafer unit; and
peeling off the second substrate.

26. The chip manufacturing method according to claim 25, wherein steps of forming the initial chip wafer unit on a side of the second substrate, the initial chip wafer unit including a plurality of initial sub-pixel light-emitting functional layers and an initial common cathode layer, and forming the temporary substrate on a side, away from the second substrate, of the plurality of initial sub-pixel light-emitting functional layers and the initial common cathode layer of the initial chip wafer unit, include:
forming a gallium nitride buffer layer, an n-type gallium nitride layer, a quantum well layer and a p-type gallium nitride layer on the side of the second substrate sequentially, and patterning the quantum well layer and the p-type gallium nitride layer to form a quantum well layer and a p-type gallium nitride layer of the initial chip wafer unit;
forming a first insulating layer on a side of the p-type gallium nitride layer away from the quantum well layer, the first insulating layer being provided therein with a plurality of via holes;
forming a fourth initial metal sub-layer and a fifth initial metal sub-layer on a side of the first insulating layer away from the second substrate, wherein the plurality of via holes provided in the first insulating layer are filled with the fourth initial metal sub-layer, and the fifth initial metal sub-layer includes a plurality of second-type metal protrusions;
providing the temporary substrate;
forming a sixth initial metal sub-layer of the initial chip wafer unit on a side of the temporary substrate; and
bonding the sixth initial metal sub-layer, the fifth initial metal sub-layer and the fourth initial metal sub-layer to form a second bonding layer, the second bonding layer including a fourth metal sub-layer, a fifth metal sub-layer and a sixth metal sub-layer, wherein the fifth metal sub-layer is arranged as a eutectic alloy layer connecting the sixth metal sub-layer and the fourth metal sub-layer;
after a step of peeling off the second substrate, the steps further include the following steps:
removing the gallium nitride buffer layer, and patterning the n-type gallium nitride layer and the first insulating layer; and
forming the first initial metal sub-layer and the second initial metal sub-layer on a side, away from the temporary substrate, of the n-type gallium nitride layer of each initial chip wafer unit, and roughening a surface of the n-type gallium nitride layer to form the initial chip wafer unit;
or after the step of peeling off the second substrate, the steps further include the following steps:
patterning the gallium nitride buffer layer, the n-type gallium nitride layer and the first insulating layer; and
forming the first initial metal sub-layer and the second initial metal sub-layer on the gallium nitride buffer layer of the initial chip wafer unit, and roughening a surface of the gallium nitride buffer layer to form the initial chip wafer unit; and a step of peeling off the temporary substrate to form a chip wafer unit, includes:
forming a second insulating layer on a side of each second bonding layer away from the color conversion layer substrate unit, the second insulating layer is provided therein with a plurality of via holes;
forming electrodes, the electrodes including a cathode electrode and anode electrodes, wherein the cathode electrode and the anode electrodes each fill a corresponding via hole of the plurality of via holes in the second insulating layer; and
thinning the first substrate to form a chip wafer.

27. The chip manufacturing method according to claim 25, wherein steps of forming the initial chip wafer unit on a side of the second substrate, the initial chip wafer unit including a plurality of initial sub-pixel light-emitting functional layers and an initial common cathode layer, and forming the temporary substrate on a side, away from the second substrate, of the plurality of initial sub-pixel light-emitting functional layers and the initial common cathode layer of the initial chip wafer unit, include:
forming a gallium nitride buffer layer, an n-type gallium nitride layer, a quantum well layer and a p-type gallium nitride layer on the side of the second substrate sequentially, and patterning the quantum well layer and the p-type gallium nitride layer to form a quantum well layer and a p-type gallium nitride layer of the initial chip wafer unit;
forming a cathode metal of the initial common cathode layer;
forming a second insulating layer on a side, away from the color conversion layer substrate unit, of the p-type gallium nitride layer and the cathode metal, the second insulating layer being provided therein with a plurality of via holes;
forming electrodes, the electrodes including a cathode electrode and anode electrodes, and the cathode electrode and the anode electrodes each fill a corresponding via hole of the plurality of via holes in the second insulating layer; and forming the plurality of initial sub-pixel light-emitting functional layers and the initial common cathode layer of the initial chip wafer unit; and
bonding the plurality of sub-pixel light-emitting functional layers and the initial common cathode layer on the temporary substrate; and
after the step of peeling off the second substrate, the steps further include the following steps:
patterning the gallium nitride buffer layer, the n-type gallium nitride layer and the second insulating layer, forming the first initial metal sub-layer and the second initial metal sub-layer on the gallium nitride buffer layer, and roughening a surface of the gallium nitride buffer layer to form the initial chip wafer unit.

28. A display device, comprising the display substrate according to claim 23.
